# EUROPEAN PATENT APPLICATION

(11) **EP 4 669 049 A1**
(43) Date of publication of application: **24.12.2025**
(21) Application number: 25182457.9
(22) Date of filing: 12.06.2025
(51) Int. Cl.: H10B 51/10, H10B 51/20, H10B 51/30, H10D 30/01, H10D 30/69, H10D 64/01, H10D 64/68

(54) **ONE-TRANSISTOR MEMORY CELL WITH A CHANNEL REGION AROUND SOURCE AND DRAIN REGIONS**

(30) Priority: 17.06.2024 US 202418745023
(71) Applicant: Intel Corporation, Santa Clara, CA 95054 (US)
(72) Inventor: SHARMA, Abhishek Anil, Portland, 97229 (US); LE, Van H., Beaverton, 97007 (US); GOMES, Wilfred, Portland, 97229 (US)
(74) Representative: 2SPL Patentanwälte PartG mbB

(57) **Abstract**

A three-dimensional (3D) memory array may include one-transistor memory cells with a channel around source and drain regions. In one example, a memory cell includes a transistor with a source (222-1) region, a drain region (222-2), an insulator material (224) between the source region and the drain region in a plane substantially parallel to a substrate, a semiconductor material (e.g., a channel region, 210) surrounding the source region and the drain region in the plane, and a hysteretic material (208) surrounding the semiconductor material in the plane. A first conductive line may be coupled with the source region, a second conductive line may be coupled with the drain region, and a third conductive line (220) including a portion of conductive material may surround the hysteretic material in the plane.

## Description

### Background

For the past several decades, the scaling of features in integrated circuits (ICs) has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize fabrication and performance of each component is becoming increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a perspective view of an example IC structure including a three-dimensional (3D) array of one-transistor memory cells with channel regions surrounding source and drain regions, in accordance with some embodiments.
FIGS. 2A-2B illustrate different cross-sectional views of an example one-transistor memory cell with a channel region surrounding a source region and a drain region, in accordance with some embodiments.
FIGS. 3A-3B illustrate different cross-sectional views of another example one-transistor memory cell with a channel region surrounding a source region and a drain region, in accordance with some embodiments.
FIGS. 4A-4B illustrate different cross-sectional views of another example one-transistor memory cell with a channel region surrounding a source region and a drain region, in accordance with some embodiments.
FIGS. 5A-5B illustrate different cross-sectional views of another example one-transistor memory cell with a channel region surrounding a source region and a drain region, in accordance with some embodiments.
FIGS. 6A-6B illustrate different cross-sectional views of another example one-transistor memory cell with a channel region surrounding a source region and a drain region, in accordance with some embodiments.
FIGS. 7A-7B illustrate different cross-sectional views of another example one-transistor memory cell with a channel region surrounding a source region and a drain region, in accordance with some embodiments.
FIG. 8 is a circuit diagram of a portion of a memory array including one-transistor memory cells, in accordance with some embodiments.
FIGS. 9A-9C illustrate examples of the circuit diagram of FIG. 8 with voltages for performing various memory accesses, in accordance with embodiments described herein.
FIG. 10 is a flow diagram of an example method for fabricating an IC structure including a one-transistor memory cell with a channel around source and drain regions, in accordance with some embodiments.
FIGS. 11A-11B, 12A-12B, 13A-13B, 14A-14B, 15A-15B, 16A-16B, 17A-17B, 18A-18B, and 19A-19B provide cross-sectional side views at various stages in the fabrication of an example IC structure according to the method of FIG. 10, in accordance with some embodiments.
FIG. 20 is a flow diagram of another example method for fabricating an IC structure including a one-transistor memory cell with a channel around source and drain regions, in accordance with some embodiments.
FIGS. 21A-21B and 22A-22B provide cross-sectional side views at various stages in the fabrication of an example IC structure according to the method of FIG. 20, in accordance with some embodiments.
FIG. 23 is a top view of a wafer and dies that may include any of the IC devices disclosed herein, in accordance with any of the embodiments disclosed herein.
FIG. 24 is a side, cross-sectional view of an IC package that may include any of the IC devices disclosed herein, in accordance with various embodiments.
FIG. 25 is a side, cross-sectional view of an IC device assembly that may include any of the IC devices disclosed herein, in accordance with any of the embodiments disclosed herein.
FIG. 26 is a block diagram of an example electrical device that may include any of the IC devices disclosed herein, in accordance with any of the embodiments disclosed herein.

### Detailed Description

Disclosed herein are integrated circuit (IC) structures including a one-transistor memory cell with a channel region around source and drain regions. The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Computer memory plays a crucial role in computing performance, with an ongoing demand for higher capacity and density in both volatile and non-volatile memories. Higher capacity memory enables handling larger datasets, while higher density allows for more compact and energy-efficient systems across various computing domains, from mobile devices to high-performance computing.

Embodiments of the present disclosure may improve on at least some of the challenges and issues of existing memory arrays, such as by increasing memory density. According to examples described herein, a three-dimensional (3D) memory array may include one-transistor memory cells with a channel around source and drain regions. In one example, a memory cell includes a transistor with a source region, a drain region, an insulator material between the source region and the drain region in a plane substantially parallel to a substrate, a semiconductor material (e.g., a channel region) surrounding the source region and the drain region in the plane, and a hysteretic material surrounding the semiconductor material in the plane. A first conductive line may be coupled with the source region, a second conductive line may be coupled with the drain region, and a third conductive line including a portion of conductive material may surround the hysteretic material in the plane. Multiple memory cells having the channel region wrapping around the source and drain region may be stacked over one another to form a 3D memory array.

IC structures as described herein, in particular IC structures including a one-transistor memory cell with a channel around source and drain regions, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of an RF receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials, and configurations are set forth in order to provide a thorough understanding of the illustrative implementations. However, it will be apparent to one skilled in the art that the present disclosure may be practiced without the specific details and/or that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of IC structures including a one-transistor memory cell with a channel region around source and drain regions as described herein.

Various aspects of the illustrative implementations will be described using terms commonly employed by those skilled in the art to convey the substance of their work to others skilled in the art. For example, the terms "oxide," "carbide," "nitride," "silicide," etc. refer to compounds containing, respectively, oxygen, carbon, nitrogen, silicon, etc.; the term "high-k dielectric" refers to a material having a higher dielectric constant than silicon oxide; the term "low-k dielectric" refers to a material having a lower dielectric constant than silicon oxide. Materials referred to herein with formulas or as compounds cover all materials that include elements of the formula or a compound, e.g., TiSi or titanium silicide may refer to any material that includes titanium and silicon, WN or tungsten nitride may refer to any material that includes tungsten and nitrogen, etc. The term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. A first component described to be electrically coupled to a second component means that the first component is in conductive contact with the second component (i.e., that a conductive pathway is provided to route electrical signals/power between the first and second components). The term "circuit" or "circuitry" means one or more passive and/or active components that are arranged to cooperate with one another to provide a desired function. As used herein, a "logic state" (or, alternatively, a "state" or a "bit" value) of a memory cell may refer to one of a finite number of states that the cell can have, e.g., logic states "1" and "0,"while "READ" and "WRITE" memory access or operations refer to, respectively, determining/sensing a logic state of a memory cell and programming/setting a logic state of a memory cell.

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

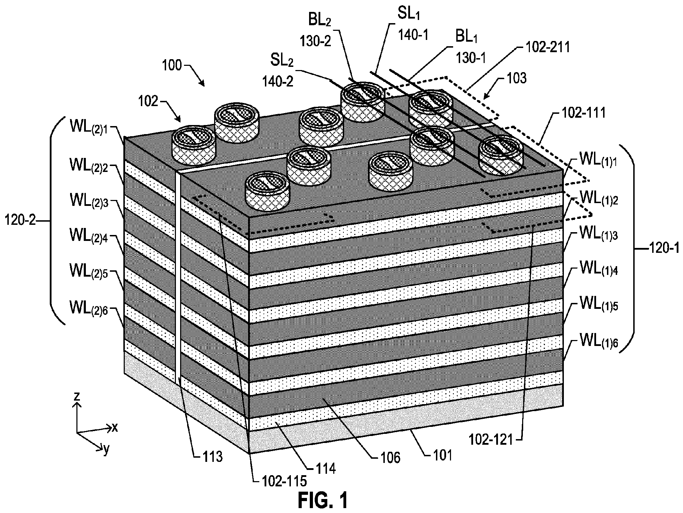

FIG. 1 is a perspective view of an example IC structure 100 including a 3D array of one-transistor memory cells with channel regions surrounding source and drain regions. The memory array may be implemented in a standalone memory device or as an embedded memory array. "Standalone" devices are included in a chip that does not also include compute logic (where, as used herein, the term "compute logic devices" or simply "compute logic" or "logic devices," refers to IC components, e.g., transistors, for performing computing/processing operations). "Embedded" memory is included in a chip along with compute logic. According to various embodiments, the memory cells of the array may be used to implement a volatile memory (e.g., such as dynamic random-access memory (DRAM)) or a substantially non-volatile memory. In some examples, the memory cells in accordance with examples described herein may be implemented as an embedded DRAM.

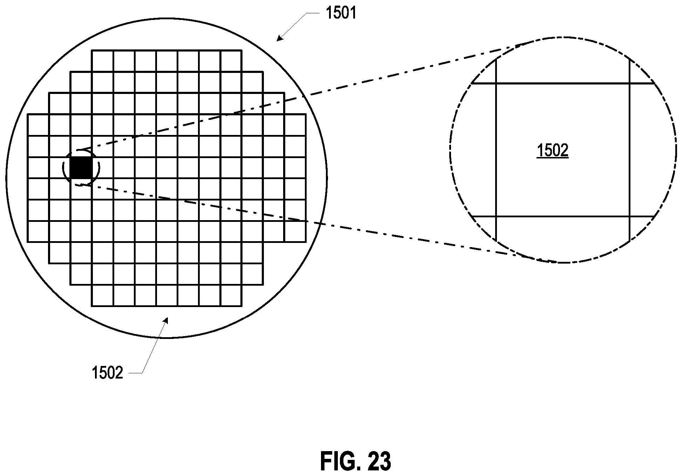

The IC structure 100 includes a stack 103 of alternate layers of a conductive material 106 and an insulator material 114 over a support 101. The support 101 may be any suitable support structure such as a substrate, a die, a wafer, or a chip. The support 101 may, e.g., be the wafer 1501 of FIG. 23, discussed below, and may be, or be included in, a die, e.g., the singulated die 1502 of FIG. 23, discussed below. The support 101 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support 101 may be a printed circuit board (PCB) substrate, a package substrate, an interposer, a wafer, or a die. Although a few examples of materials from which the support 101 may be formed are described here, any material that may serve as a foundation upon which an IC structure as described herein may be built falls within the spirit and scope of the present disclosure.

The insulator material 114 may include any suitable insulator material, such as an interlayer dielectric (ILD) or other insulator material. Examples of ILDs may include silicon oxide, silicon nitride, aluminum oxide, and/or silicon oxynitride. The conductive material 106 may include any suitable electrically conductive material, which may include an alloy or a stack of multiple electrically conductive materials. In some embodiments, such electrically conductive materials may include one or more metals or metal alloys, with metals such as ruthenium, palladium, platinum, cobalt, nickel, hafnium, zirconium, titanium, tantalum, and aluminum. In some embodiments, such electrically conductive materials may include one or more electrically conductive alloys oxides or carbides of one or more metals. In some examples, the material 106 may include polysilicon or another semiconductor material.

Referring again to FIG. 1, a plurality of memory cells 102 are formed in openings or holes in the stack 103, where a memory cell includes a single transistor located in an opening in the stack in a plane with a layer of the conductive material 106. Accordingly, multiple transistors, and thus multiple memory cells 102, may be stacked over one another in a given opening in the stack 103, where each of the memory cells 102 in a given opening are located at a different layer of the conductive material 106. The memory array of FIG. 1 may therefore be considered a 3D memory array due to the presence of memory cells 102 in the array along three axes (e.g., memory cells 102 are arranged both in x-y planes and vertically along the z-axis, as shown in FIG. 1).

The memory array of FIG. 1 includes a plurality of control lines (which may also be referred to as access lines or conductive lines) for accessing the memory cells 102 (e.g., access to write information to the memory cell 102 or access to read information from the memory cells 102). Specifically, the IC structure 100 includes first control lines 130 (of which control lines 130-1 and 130-2 are shown), second control lines 140 (of which control lines 140-1 and 140-2 are shown), and third control lines 120-1, 120-2. According to examples, a first control line 130 may be coupled with one source or drain region ("S/D region") of a vertical stack of transistors and a second control line 140 may be coupled with the other S/D region of the vertical stack of transistors. As is discussed in more detail below, the S/D regions in an opening may be shared by multiple transistors in the opening. For example, the memory cell 102-111 and the memory cell 102-121 may share S/D region, and therefore the control lines 130-1, 140-1 are coupled with the S/D regions of both the memory cells 102-111 and 102-121. In the example illustrated in FIG. 1, the control lines 130 are referred to as bitlines (BLs) and the control lines 140 are referred to as source lines (SLs), however, the designation of bitline and source line may be reversed (e.g., the control lines 130 may be source lines and the control lines 140 may be bitlines), and/or the control lines may be referred to with different terms (e.g., the source lines or the bitlines may be referred to as platelines).

In the example illustrated in FIG. 1, a third control line 120 includes a portion of conductive material 106 that surrounds a transistor of a memory cell 102. In particular, in accordance with examples, a portion of the conductive material 106 surrounds the hysteretic element of the transistor, as discussed in more detail below. In the example illustrated in FIG. 1, the control lines 120-1, 120-2 are referred to as wordlines (WLs). The stack 103 may include one or more insulator regions 113 that extend through the layers of conductive material 106 of the stack 103 to separate the layers of conductive material 106 into first control lines 120-1 and second control lines 120-2. The example illustrated in FIG. 1 depicts six layers of the conductive material 106, and thus six wordlines in each of the groups of control lines 120-1, 120-2. The wordlines shown in FIG. 1 are labeled WL(i)(m), where 'i' represents a group of stacked wordlines, and m represents the wordline in the stack. Therefore, FIG. 1 depicts the first control lines 120-1 as including WL(1)(1), WL(1)(2), WL(1)(3), WL(1)(4), WL(1)(5), and WL(1)(6), and the second control lines 120-2 as including WL(1)(1), WL(1)(2), WL(1)(3), WL(1)(4), WL(1)(5), and WL(1)(6). In other examples, a memory array may include fewer than six layers of conductive material (and therefore fewer than six stacked wordlines) or more than six layers of conductive material (and therefore more than six stacked wordlines). Although only two stacks of control lines 120-1, 120-2 are depicted, in other examples, the layers of conductive material 106 may be separated into more than two stacks with multiple insulator regions 113.

A control line may be coupled with multiple memory cells, where each memory cell is uniquely addressable or accessible with a combination of control lines 120, 130, and 140 (e.g., a combination of wordline, bitline, and source line). For example, the memory cell 102-111 is accessible with WL(1)1, BL1, and SL1, the memory cell 102-121 is accessible with WL(1)(2), BL1, and SL1, and the memory cell 102-211 is accessible with WL(2)1, BL1, and SL1. Thus, the bitline BL1 and the source line SL1 are coupled with both the memory cell 102-111 and the memory cell 102-211, however, they are uniquely addressable because the memory cell 102-111 is coupled with a different wordline (i.e., the wordline WL(1)1) than the memory cell 102-211 (which is coupled with the wordline W(2)(1). Similarly, the wordline W(1)1 is coupled with multiple memory cells in a layer with the WL(1)1, such as the memory cell 102-111 and the memory cell 102-115.

Thus, the IC structure 100 includes a stack 103 of alternate layers of an insulator material 114 and a conductive material 106, where the stack includes at least a first layer of the conductive material 106 (e.g., the layer of conductive material 106 that forms the WL(1)1) and a second layer of the conductive material 106 (e.g., the layer of conductive material 106 that forms the WL(1)2), a first memory cell (e.g., the memory cell 102-111) including a first transistor in the first layer in an opening in the stack 103, and a second memory cell (e.g., the memory cell 102-121) including a second transistor in the second layer in the opening, where the first transistor and the second transistor include a channel region surrounding the source region and drain region.

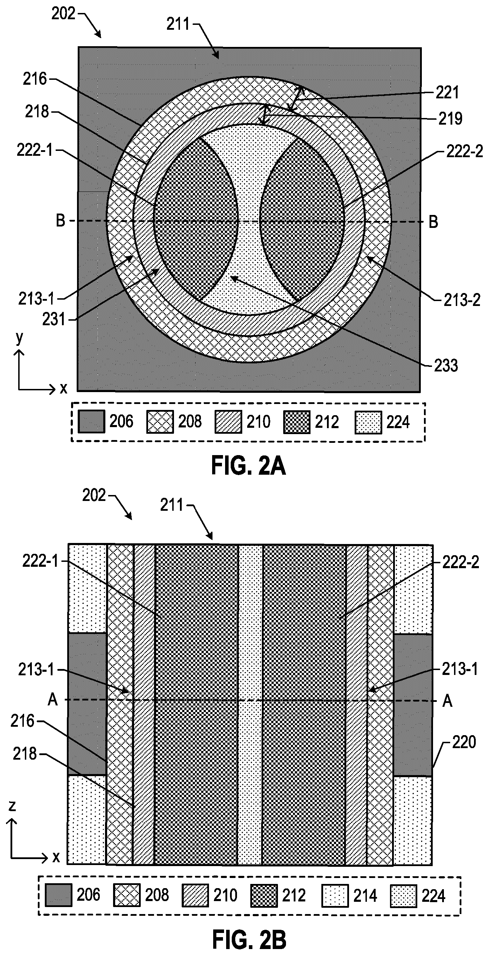

FIGS. 2A-2B illustrate different cross-sectional views of an example one-transistor memory cell 202 with a channel region 218 surrounding a first S/D region 222-1 and a second S/D region 222-2. FIG. 2A illustrates a cross-sectional view in the x-y plane along a cut through a layer of the conductive material surrounding the memory cell 202 (e.g., along the AA plane shown in FIG. 2B). FIG. 2B illustrates a cross-sectional view in the x-z plane along a cut through an approximate middle of the memory cell 202 (e.g., along the BB plane shown in FIG. 2A).

The memory cell 202 is an example of the memory cells 102 of FIG. 1. As can be seen in FIG. 2B, the memory cell 202 is in an opening in a stack of alternate layers of a conductive material 206 and an insulator material 214. The memory cell 202 includes a transistor 211, where the transistor 211 includes a first S/D region 222-1 and a second S/D region 222-2, where one of the regions 222-1, 222-2 is a source region and another of the regions 222-1, 222-2 is a drain region. The first S/D region 222-1 and the second S/D region 222-2 include an S/D material 212, which may include a conductive material including a metal or a doped semiconductor material. Examples of conductive materials from which the S/D regions 222-1, 222-2 may be formed include one or more of: tungsten, molybdenum, ruthenium, and/or any other suitable conductive material. Examples of semiconductor materials from which the regions 222-1, 222-2 may be formed include one or more of: a semiconductor including oxygen (e.g., one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO), indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus. In examples in which the S/D regions 222-1, 222-2 include a semiconductor material, the semiconductor material be doped with one or more of gallium, indium, aluminum, fluorine, boron, phosphorus, arsenic, nitrogen, tantalum, tungsten, and magnesium, etc.

The transistor 211 includes an insulator material 224 between the first S/D region 222-1 and the second S/D region. As can be seen in FIGS. 2A-2B, the first S/D region 222-1 is separated from and electrically isolated from the second S/D region 222-2 by the insulator material 224. The insulator material may include any suitable insulator material, such as an ILD or other insulator material. In the example illustrated in FIG. 2A, the S/D regions 222-1, 222-2 have a cross-sectional shape that is curved and convex. Specifically, in the example in FIG. 2A, the S/D regions 222-1 includes a first portion 231 (a "sidewall-facing portion") that conforms to the contour of the sidewall of the opening in which the memory cell is formed, and a second portion 233 opposite the sidewall-facing portion 231. The second portion 233 has a cross-sectional shape that is curved and convex (e.g., curving away from the sidewall-facing portion 231). The second portion 233 is in contact with the insulator material 224, and the first portion 231 is in contact with the semiconductor material 210.

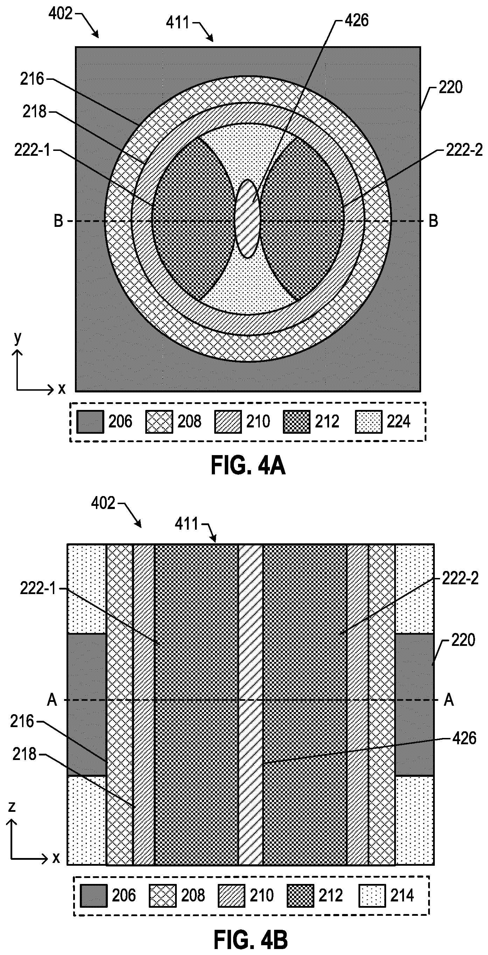

In the example illustrated in FIG. 2A, as a result of the curved shape of S/D regions 222-1, 222-2, the insulator material 224 between the S/D regions 222-1, 222-2 has different widths between different portions of the S/D regions 222-1, 222-2, where the width is a dimension of the insulator material 224 in a plane substantially parallel with the substrate between the first S/D region 222-1 and the second S/D region 222-2 (e.g., along the x-axis). For example, the width of the insulator material 224 in a middle portion of the memory cell is narrower than a width of the insulator material 224 near or in contact with the semiconductor material 210. Although not labeled for the S/D region 222-2, the second S/D region 222-2 also has a curved convex portion in contact with the insulator material 224 (e.g., where the S/D regions 222-1 and 222-2 have cross-sectional shapes that are substantially mirrored across an axis (e.g., across the y-axis shown in FIG. 2A) between the S/D regions 222-1, 222-2). In other examples, the S/D regions 222-1, 222-2 may have other shapes than the curved convex shape shown in FIG. 4A.

The transistor 211 further includes a semiconductor material 210 surrounding the first and second S/D regions 222-1, 222-2. In the example illustrated in FIG. 2A, there is a layer of the semiconductor material 210 over the sidewalls of the opening (e.g., over the hysteretic material 208 on the sidewalls of the opening) in which the transistor 211 is formed. Put another way, there is a layer of the semiconductor material 210 on sidewalls of an inner structure including the S/D regions 222-1, 222-2. In the example illustrated in FIGS. 2A-2B, the layer of the semiconductor material 210 is a substantially conformal layer, where a conformal layer is a layer of material that has a substantially uniform thickness (e.g., within about one or two nanometers) on surfaces over which the layer was deposited. According to examples, a thickness 219 of the layer of semiconductor material 210 may be in a range of about 3 to 20 nanometers, where the thickness is a dimension of the semiconductor material 210 in a plane substantially parallel to the substrate (e.g., in the x-y plane as shown in FIG. 2A); however, in other examples, the layer of the semiconductor material 210 may be greater than 20 nanometers. In the example illustrated in FIGS. 2A-2B, a channel region 218 of the transistor 211 includes a portion of the semiconductor material 210 in the layer or plane with the conductive material 206.

The semiconductor material 210 may include any suitable channel material, such as the semiconductor materials mentioned above with respect to the S/D regions 222-1, 222-2. In some examples, the semiconductor material 210 of the channel region 218 and the S/D material 212 of the S/D regions 222-1, 222-2 may include the same semiconductor material. In one such example, the S/D regions 222-1, 222-2 may include dopants that are not present in the channel region 218, and/or dopants at a higher concentration than in the channel region 218. In some embodiments, the S/D regions 222-1, 222-2 may be highly doped, e.g., with dopant concentrations of about 10²¹ cm⁻³, although these regions may also have lower dopant concentrations in some implementations. Irrespective of the exact doping levels, the S/D regions 222-1, 222-2 of the transistor 211 are the regions having dopant concentrations higher than in other regions, e.g., higher than a dopant concentration in the transistor channel region 218 (i.e., in the semiconductor material 210), and, therefore, may be referred to as "highly doped" regions. Even when doped (e.g., to realize threshold voltage tuning), the channel region 218 typically includes a semiconductor material with doping concentrations significantly smaller than those of the S/D regions 222-1, 222-2.

The transistor 211 also includes a hysteretic material 208 surrounding the semiconductor material 210. In the example illustrated in FIG. 2A, there is a layer of the hysteretic material 208 on the sidewalls of the opening in which the transistor 211 is formed. Put another way, there is a layer of the hysteretic material 208 over the semiconductor material 210 on sidewalls of an inner structure including the S/D regions 222-1, 222-2. In the example illustrated in FIGS. 2A-2B, the layer of the hysteretic material 208 is a substantially conformal layer. According to examples, a thickness 221 of the layer of hysteretic material 208 may be in a range of about 3 to 20 nanometers, where the thickness is a dimension of the hysteretic material 208 in a plane substantially parallel to the substrate (e.g., in the x-y plane as shown in FIG. 2A); however, in other examples, the layer of the hysteretic material 208 may be greater than 20 nanometers.

In one example, a hysteretic element 216 of the transistor includes a portion of the hysteretic material 208 surrounding the channel region 218. In some embodiments, the hysteretic element 216 may be provided as a layer of a ferroelectric (FE) or an antiferroelectric (AFE) material. Such an FE/AFE material may include one or more materials that can exhibit sufficient FE/AFE behavior even at thin dimensions, e.g., such as an insulator material at least about 5%, e.g., at least about 7% or at least about 10%, of which is in an orthorhombic phase and/or a tetragonal phase (e.g., as a material in which at most about 95-90% of the material may be amorphous or in a monoclinic phase). For example, such materials may be based on hafnium and oxygen (e.g., hafnium oxides), with various dopants added to ensure sufficient amount of an orthorhombic phase or a tetragonal phase. Some examples of such materials include materials that include hafnium, oxygen, and zirconium (e.g., hafnium zirconium oxide (HfZrO, also referred to as HZO)), materials that include hafnium, oxygen, and silicon (e.g., silicon-doped (Si-doped) hafnium oxide), materials that include hafnium, oxygen, and germanium (e.g., germanium-doped (Ge-doped) hafnium oxide), materials that include hafnium, oxygen, and aluminum (e.g., aluminum-doped (Al-doped) hafnium oxide), and materials that include hafnium, oxygen, and yttrium (e.g., yttrium-doped (Y-doped) hafnium oxide). However, in other embodiments, any other materials which exhibit FE/AFE behavior at thin dimensions may be used as the hysteretic element 216 and are within the scope of the present disclosure.

In other embodiments, the hysteretic element 216 may be provided as a stack of alternating layers of materials that can trap charges. In some such embodiments, the stack may be a two-layer stack, where one layer is a charge-trapping layer and the other layer is a tunnelling layer. The tunnelling layer may include an insulator material such as a material that includes silicon and oxygen (e.g., silicon oxide), or any other suitable insulator. The charge-trapping layer may include an electrically conductive material such as a metal, or a semiconductor material. In some embodiments, the charge-trapping layer may include a material that includes silicon and nitrogen (e.g., silicon nitride). In general, any material that has defects that can trap charge may be used in/as a charge-trapping layer. Such defects are very detrimental to operation of logic devices and, therefore, typically, deliberate steps need to be taken to avoid presence of the defects. However, for memory devices, such defects are desirable because charge-trapping may be used to represent different memory states of a memory cell. In some embodiments of the hysteretic element 216 being provided as a stack of alternating layers of materials that can trap charges, the stack may be a three-layer stack where an insulator material is provided on both sides of a charge-trapping layer. In such embodiments, a layer of an insulator material on one side of the charge-trapping layer may be referred to as a "tunnelling layer" while a layer of an insulator material on the other side of the charge-trapping layer may be referred to as a "field layer."

The memory cell 202 can be written to or read using control lines, e.g., by applying appropriate voltages on one or more control lines, and in the case of a read operation, sensing an electrical output (e.g., sensing the magnitude and/or change in magnitude of a charge, voltage, or current) on a control line. In the example illustrated in FIG. 2A, the conductive material 206 forms one control line 220 (e.g., a wordline), where a portion of the conductive material 206 wraps at least partially around the hysteretic material 208. In the example in FIG. 2A, the conductive material 206 completely surrounds (e.g., wraps entirely around) the hysteretic material 208 in the x-y plane in the cut shown in FIG. 2A. Another control line (e.g., a bitline) may be coupled with one of the S/D regions (e.g., the S/D region 222-1) and another control line (e.g., a source line) may be coupled with the other S/D region (e.g., the S/D region 222-2).

Accordingly, the transistor 211 includes a layer of hysteretic material 208 on sidewalls of an opening, a layer of semiconductor material 210 over the hysteretic material 208 on sidewalls, and S/D regions 222-1, 222-2 within the layer of semiconductor material 210. In the example illustrated in FIGS. 2A-2B, the conductive material 206 is in contact with (e.g., in direct contact with and without an intervening layer) the hysteretic element 216, the hysteretic element 216 is in contact with (e.g., in direct contact with) the semiconductor material 210, and the semiconductor material 210 is in direct contact with the S/D regions 222-1 and 222-2. Thus, the transistor 211 includes a channel region 218 surrounding the S/D regions 222-1, 222-2, which are separated from one another by an insulator material 224. In one example, the first S/D region 222-1 includes a first continuous portion of a conductive material or a doped semiconductor material in contact with and between a first portion 213-1 of the semiconductor material 210 and the insulator material 224. The second S/D region 222-2 includes a second continuous portion of the conductive material or the doped semiconductor material in contact with and between a second portion 213-2 of the semiconductor material 210 and the insulator material 224 (where the second portion 213-2 of the semiconductor material 210 is opposite, e.g., on opposing sidewall portions, the first portion 213-1 of the semiconductor material 210 in the x-y plane as shown in FIG. 2A).

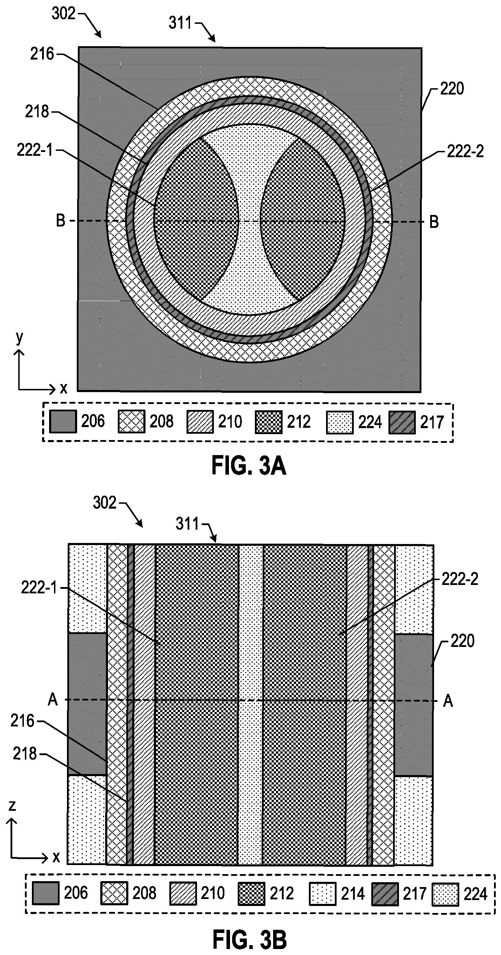

FIGS. 2A-2B illustrate an example in which the hysteretic element 216 is between the conductive material 206 and the channel region 218. In some examples, a transistor may further include a gate insulator material between the hysteretic element and the channel region. For example, FIGS. 3A-3B illustrate different cross-sectional views of an example memory cell 302 including a transistor 311 that includes a gate insulator material 217 between the hysteretic material 208 and the semiconductor material 210. According to examples, a thickness of the layer of gate insulator material 217 may be in a range of about 0.5 and 3 nanometers, about 1 and 3 nanometers, or about 1 and 2 nanometers where the thickness is a dimension of the thickness of the gate insulator material 217 in a plane substantially parallel to the substrate (e.g., in the x-y plane as shown in FIG. 2A). The gate insulator material 217 may be any suitable gate insulator material (e.g., a gate dielectric material). In some embodiments, the gate insulator material 217 may include one or more high-k dielectrics including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

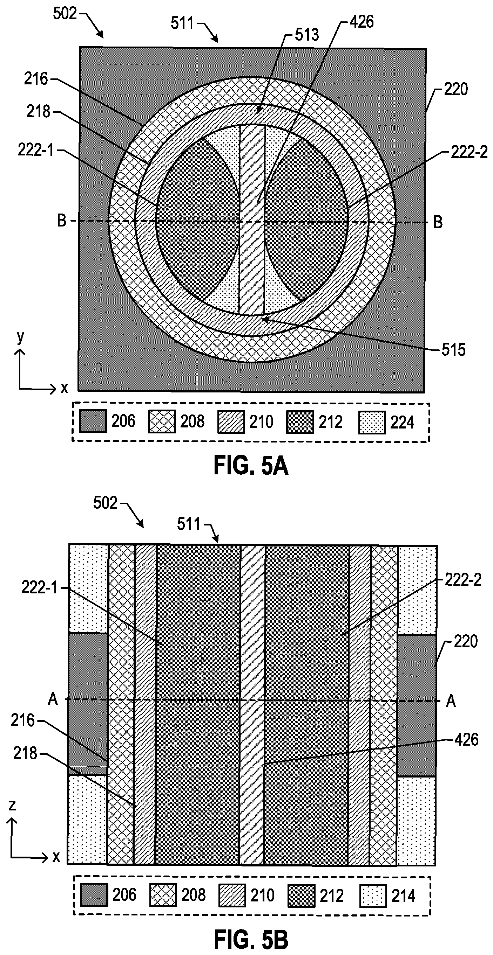

As shown in FIGS. 2A-2B and 3A-3B, the S/D regions 222-1 and 222-2 are separated from one another in the memory cell opening with an insulator material 224. In some examples, a second isolation region or isolation structure may be formed between the S/D regions 222-1 and 222-2 (e.g., near a middle of the opening) to ensure electrical isolation of the first S/D region 222-1 from the second S/D region 222-2. In one such example, a second isolation region may include an insulator material between portions of the S/D regions 222-1 and 222-2, or an insulator material that extends between the entire extent of the S/D regions 222-1 and 222-2. FIGS. 4A-4B illustrate different cross-sectional views of an example memory cell 402 including a transistor 411 with a second insulator material between portions of the S/D regions 222-1 and 222-2. FIGS. 5A-5B illustrate different cross-sectional views of an example memory cell 502 including a transistor 511 with a second insulator material that extends between the entire extent of the S/D regions 222-1 and 222-2.

Turning first to FIG. 4A, in a cross-section along the x-y plane, the transistor includes a second insulator material 426 between a portion of the S/D region 222-1 and a portion of the S/D region 222-2. The second insulator material 426 may have a different material composition than the insulator material 224. For example, the insulator material 224 may be silicon oxide or another insulator material, and the second insulator material 426 may be silicon nitride or another insulator material that is different from the insulator material 224. In the example illustrated in FIGS. 4A-4B, the second insulator material is between the S/D regions 222-1, 222-2 along a first axis in the plane (e.g., along the x-axis as shown in FIG. 4A), where the second insulator material 426 is between portions of the first insulator material 224 along a second axis in the plane (e.g., along the y-axis as shown in FIG. 4A), where the second axis is orthogonal to the first axis.

In one example, the second insulator material 426 is between the S/D regions 222-1, 222-2 at a point where the distance between the S/D region 222-1 and 222-2 is smallest to ensure electrical isolation between the regions 222-1, 222-2 at that point. For example, due to the curved convex shape of the S/D regions 222-1, 222-2 of FIG. 4A, the S/D material 212 of the S/D region 222-1 is closest to the S/D material 212 of the S/D region 222-2 at the approximate middle of the memory cell. Therefore, in the example illustrated in FIG. 4A, the second insulator material 426 is at the approximate middle or central region of the opening between the S/D regions 222-1, 222-2. In other examples in which the memory cell has a different cross-sectional shape (e.g., an oval shape or other shape) and/or in which the S/D regions 222-1, 222-2 have a different cross-sectional shape, the second insulator material 426 may be located in a different region of the memory cell between the S/D regions 222-1, 222-2 than shown in FIGS. 4A-4B. As can be seen in FIG. 4B, the second insulator material 426 includes a continuous portion of the second insulator material 426 that extends through the stack between the S/D regions 222-1, 222-2.

In the example illustrated in FIGS. 4A-4B, the second insulator material 426 has a cross-sectional shape that is oval (e.g., a substantially oval shape in a cross-section in a plane substantially parallel with a substrate, such as in the x-y plane shown in FIG. 4A). In the example illustrated in FIG 4A, the oval cross-sectional shape of the second insulator material 426 has a longer width along the y-axis (e.g., along the axis that extends between the two S/D regions 222-1, 222-2 without intersecting the S/D regions 222-1, 222-2). In other examples, the second insulator material 426 may have other shapes. For example, the second insulator material 426 may have a cross-sectional circular shape, or may have a cross-sectional shape that is substantially rectangular (e.g., such as in FIGS. 5A-5B).

Turning now to FIGS. 5A-5B, the memory cell 502 includes a transistor 511 with a "sheet" of the second insulator material 426. Specifically, referring to FIG. 5A, a region of the second insulator material 426 that extends between the S/D regions 222-1 and 222-2 in the y-z plane (e.g., in a plane orthogonal to the substrate that does not cut through the S/D regions 222-1, 222-2). Thus, instead of a region of the second insulator material 426 between only portions of the S/D regions 222-1, 222-2 as in FIGS. 4A-4B, the second insulator material 426 in FIGS. 5A-5B includes a continuous portion that is in contact with and extends between a first portion 513 of the semiconductor material 210 and a second portion 515 of the semiconductor material 210 that is opposite to the first portion 513.

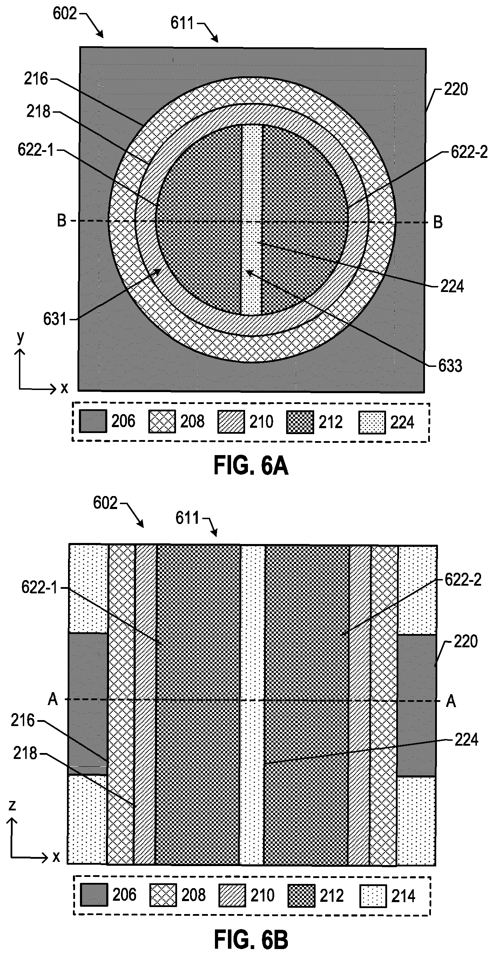

FIGS. 2A-2B, 3A-3B, 4A-4B, and 5A-5B all illustrate examples of transistors in which the S/D regions 222-1, 222-2 have a curved shape. FIGS. 6A-6B illustrate different cross-sectional views of an example memory cell 602 including a transistor 611 with S/D regions 622-1, 622-2 that have a substantially straight profile. Specifically, in the example in FIG. 6A, the S/D region 622-1 includes a first portion 631 (a "sidewall-facing portion") that conforms to the contour of the sidewall of the opening in which the memory cell is formed, and a second portion 633 opposite the sidewall-facing portion 631. The second portion 633 is a substantially straight portion in contact with the insulator material 224 in a cross-section of the memory cell 602 in the x-y plane. Thus, the second portion 633 is in contact with the insulator material 224, and the first portion 631 is in contact with the semiconductor material 210. In the example illustrated in FIG. 6A, as a result of the straight profile of S/D regions 622-1, 622-2, the insulator material 224 between the S/D regions 622-1, 622-2 has a substantially uniform width between different portions of the S/D regions 622-1, 622-2, where the width is a dimension of the insulator material 224 in a plane substantially parallel with the substrate between the first S/D region 622-1 and the second S/D region 622-2 (e.g., along the x-axis). The second S/D region 622-2 also has a substantially straight portion in contact with the insulator material 224 (e.g., where the S/D regions 622-1 and 622-2 have cross-sectional shapes that are substantially mirrored across an axis (e.g., across the y-axis shown in FIG. 6A) between the S/D regions 622-1, 622-2).

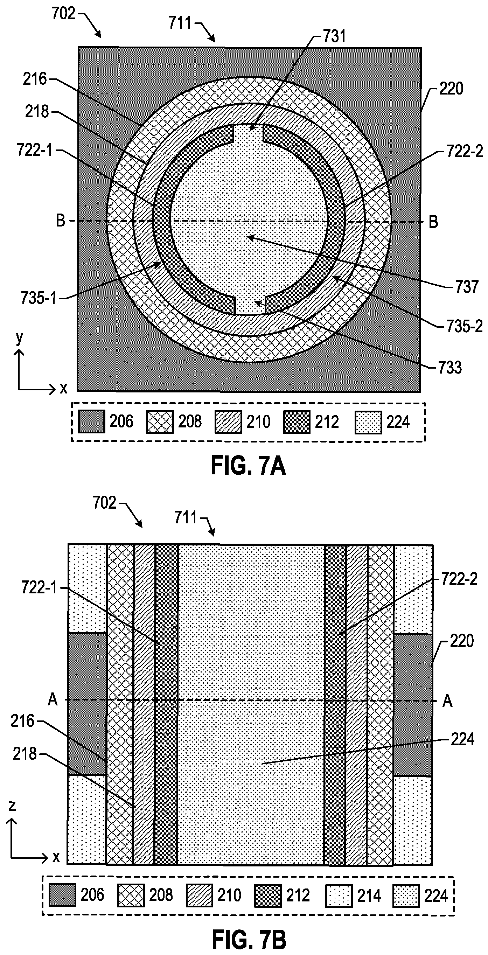

FIGS. 7A-7B illustrate different cross-sectional views of an example memory cell 702 including a transistor 711 with S/D regions 722-1 and 722-2 that include two regions of a conformal layer of the S/D material 212 over the semiconductor material 210 on the sidewalls. As can be seen in FIGS. 7A-7B, the S/D regions 722-1, 722-2 include a first portion 735-1 of a layer of the S/D material 212 and a second portion 735-2 of the S/D material 212 that is opposite the first portion 735-1 in the opening in which the transistor 711 is formed. In the example illustrated in FIG. 7A, the portions 735-1, 735-2 are portions of a conformal layer of the S/D material 212 on the sidewalls of the opening in which the transistor 711 was formed, where the conformal layer has two discontinuities or gaps (e.g., the regions 731, 733) to electrically isolate the two portions 735-1, 735-2. The gaps or discontinuities in the conformal layer of the material 212 may be formed by etching the material 212 and filling the material with the insulator material 224. Thus, each of the S/D regions 722-1, 722-2 includes a layer of the S/D material 212 with a substantially uniform thickness along the sidewalls, where the thickness is a dimension of the layer in a plane substantially parallel to the substrate over which the memory cell 702 is formed (e.g., in the x-y plane as shown in FIG. 7A), and the S/D regions are separated from one another with regions 731, 733 of an insulator material.

Also, in the example illustrated in FIG. 7A, the S/D regions 722-1, 722-2 have shapes that conform to the sidewalls of the opening in which the transistor 711 was formed. The first portion 735-1 is separated and electrically isolated from the second portion 735-2 by the regions 731, 733 of the insulator material 224. Although a continuous portion of the same insulator material 224 is shown in FIG. 7A as being between the S/D regions 722-1, 722-2, in other examples, more than one insulator material may be present in the regions between the first S/D region 722-1 and the second S/D region 722-2. For example, the regions 731, 733 proximate to (or in contact with) the semiconductor material 210 on the sidewalls of the opening may be filled with a different insulator material than in a middle region 737 between the S/D regions 722-1, 722-2 (where the middle region 737 is a region that may encompass an approximate middle or center of the transistor 711 in a cross-section along a cut through the conductive material 206 as shown in FIG. 7A). In the example illustrated in FIGS. 7A-7B, due to the S/D regions 722-1, 722-2 being formed from a conformal layer of the S/D material 212, the S/D region 722-1 is at a greater distance from the S/D region 722-2 (e.g., in a middle region 737 along the x-axis), and therefore may have a lower capacitance than examples in which the S/D regions are closer together. For example, in FIGS. 7A-7B, the distance between the two S/D regions 722-1, 722-2 in a middle region 737 of the transistor is greater than in the examples shown in FIGS. 2A-2B, 3A-3B, 4A-4B, 5A-5B, and 6A-6B, which may reduce capacitance in the transistor 711. Thus, unlike in the example shown in FIG. 6A, where the insulator material 224 has a substantially uniform width, in the example illustrated in FIGS. 7A-7B, a width of the insulator material 224 between the first S/D region 722-1 and the second S/D region 722-2 is greatest in the middle region 737.

Accordingly, FIGS. 7A-7B illustrate an example in which the S/D regions 722-1, 722-2 may be formed with a substantially conformal layer of the S/D material 212 on the sidewalls of the opening, where the substantially conformal layer includes separations or gaps that electrically isolate the two S/D regions 722-1, 722-2. In an example such as FIGS. 7A-7B in which the transistor 711 has a substantially round (e.g., circular) cross section, a cross section of the transistor 711 includes a discontinuous ring or layer (e.g., a ring or layer with discontinuities) of the S/D material 212 inside a ring or layer of the semiconductor material 210 (e.g., the channel material), which is inside a ring or layer of the hysteretic material 208.

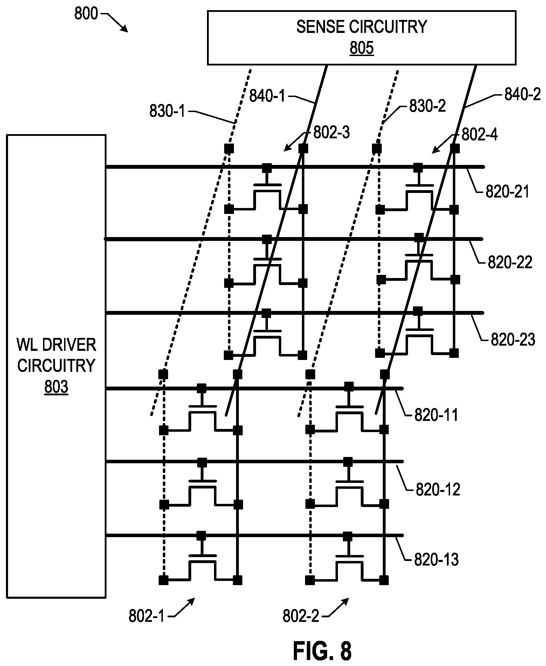

FIG. 8 is a circuit diagram of a portion of a memory array including one-transistor memory cells in accordance with embodiments described herein. The memory array 800 includes a plurality of memory cells 802-1, 802-2, 802-3, and 802-4 (referred to herein as "memory cells 802," where a memory cell 802 is represented with a transistor symbol in FIG. 8). Labels are not included for each individual memory cell in the array 800 in order to not obscure the details of the drawing. Instead, each group or stack of memory cells is labeled. In the example illustrated in FIG. 8, four groups or stacks of memory cells are shown. Specifically, the memory cells 802-1 represent one group of memory cells that are stacked over one another in a hole in a stack of alternate layers of a conductive material and an insulator material, and the memory cells 802-2 represent another group of memory cells that are stacked over one another in another hole (e.g., an adjacent hole) in the same stack. Thus, the memory cells 802-1 and 802-2 share the same wordlines 820-11, 820-12, and 820-13 (where the wordlines are referred to herein as "wordlines 820"). Although the memory cells 802-1 and 802-2 are coupled with the same wordlines, the memory cells 802-1 and 802-2 are coupled with different bitlines and source lines, and are therefore a unique combination of wordline, source line, and bitline may be used to access a given one of the memory cells 802-1 and 802-2. Specifically, the memory cells 802-1 are coupled with the bitline 830-1 and the source line 840-1, and the memory cells 802-2 are coupled with the bitline 830-2 and the source line 840-2 (where the bitlines are referred to herein as "bitlines 830" and the source lines are referred to herein as "source lines 840").

Similarly, the memory cells 802-3 represent one group of memory cells that are stacked over one another in a hole in another stack of alternate layers of a conductive material and an insulator material, and the memory cells 802-4 represent another group of memory cells that are stacked over one another in another hole (e.g., an adjacent hole) in the same stack. Thus, the memory cells 802-2 and 802-3 share the same wordlines 820-21, 820-22, and 820-23. In some examples, the wordlines 820-11, 820-12, and 820-13 and the wordlines 820-21, 820-22, and 820-23 may be electrically insulated from one another with an insulator region, such as the insulator region 113 of FIG. 1. The memory cells 802-3 and 802-4 are coupled with different bitlines and source lines, and are therefore a unique combination of wordline, source line, and bitline may be used to access a given one of the memory cells 802-3 and 802-4. Specifically, the memory cells 802-3 are coupled with the bitline 830-1 and the source line 840-1, and the memory cells 802-4 are coupled with the bitline 830-2 and the source line 840-2.

The wordlines 820 are coupled with wordline driver circuitry 803. The wordlines driver circuitry 803 includes circuitry to apply appropriate voltages to the wordlines 820 in order to write to (e.g., store a logic value) one or more memory cells of the array 800 or read from a memory cell of the array. The bitlines 830 and source lines 840 are coupled with sense circuitry 805. The sense circuitry 805 may include a sense amplifier configured to sense a current or voltage (e.g., current in a bitline 830) and convert the magnitude of the sensed current or voltage to a digital logic value. In some examples, the current or voltage may depend on the polarization state of a memory cell with a ferroelectric or antiferroelectric element or the presence of charge in a memory cell with a charge-trapping arrangement. Therefore, sensing the magnitude of current or voltage allows a determination of the logical value stored in a memory cell 802.

Although the memory array 800 depicted in FIG. 8 only depicts two wordline stacks and two stacks or memory cells coupled with the wordlines in each of the wordline stacks, memory arrays will generally include many more wordlines and memory cells than depicted in FIG. 8. Thus, a memory array may include multiple wordline stacks (where a wordline stack is a portion of a stack of alternate layers of conductive material and insulator material that is electrically insulator from other portion of the stack by an insulator region) where each wordline stack includes multiple wordlines, and where a plurality of memory cells may be coupled with each wordline. Also, although each stack of memory cells is shown as including three memory cells in FIG. 8, a stack of memory cells may include fewer than three or more than three memory cells (e.g., two memory cells, four memory cells, eight memory cells, etc.).

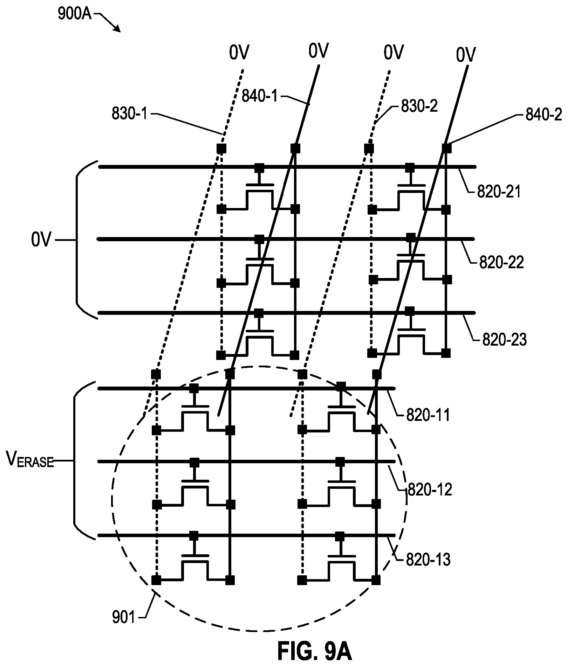

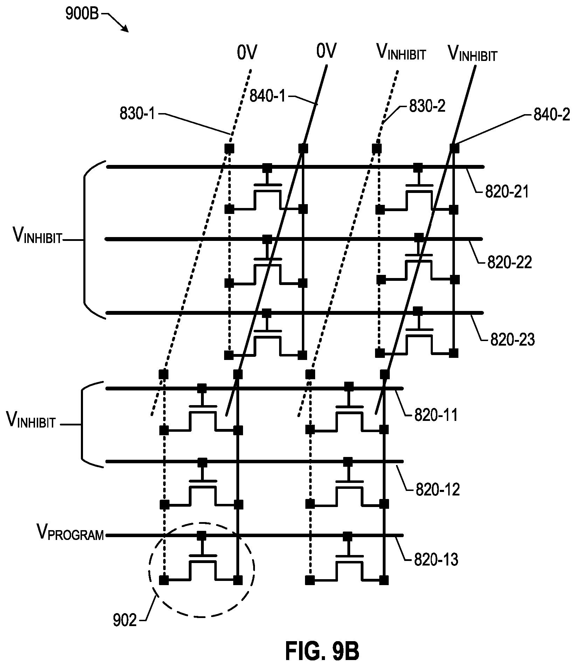

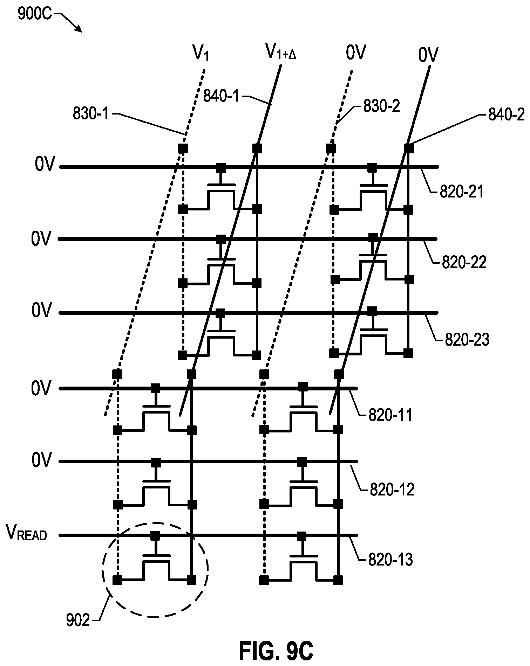

FIGS. 9A-9C illustrate examples of the circuit diagram of FIG. 8 with applied voltages for performing various memory accesses, in accordance with embodiments described herein. FIG. 9A illustrates an example circuit diagram with voltages for performing an erase or reset operation. FIG. 9B illustrates an example circuit diagram with voltages for performing a program or set operation. FIG. 9C illustrates an example circuit diagram with voltages for performing read operation.

Turning first to FIG. 9A, the circuit diagram 900A depicts an example of voltages applied to control lines in order to erase or reset a group of memory cells 901. In an example in which the memory cells include FE or AFE storage elements, an erase operation may involve applying a sufficiently high voltage with a particular polarity to put the FE/AFE element of the memory cell into a polarization state associated with an erased state. In an example in which the memory cells include charge-trapping storage elements, an erase operation may involve applying a sufficiently high voltage to remove charge from the charge-trapping element. According to one example, an erased state may represent a logic '0'; however, the states of a memory cell may be assigned to represent a logic '0' and logic '1', and therefore an erased state may alternatively represent a logic '1'.

Referring again to FIG. 9A, the source lines 840 and the bitlines 830 are held at 0 V. The wordlines coupled with memory cells that are not to be erased (which may be referred to as unselected wordlines) are also held at 0 V. In the example illustrated in FIG. 9A, 0 V is applied to the wordlines 820-21, 820-22, and 820-23, the bitlines 830-1 and 830-2, and the source lines 840-1 and 840-2. A voltage V_{ERASE} is applied to the wordlines of memory cells that are to be erased (which may be referred to as selected wordlines), where V_{ERASE} has a magnitude that is sufficiently high to put the memory cell in an erased state. If one of the memory cells 901 was not in an erased state prior to the erase operation, application of the voltage V_{ERASE} may evoke a change (e.g., a change in polarization state or a change in charge stored in a charge-trapping layer) in the hysteretic element of the memory cell to put the memory cell in an erased state. For the memory cells to which V_{ERASE} is applied, a voltage of about V_{ERASE} (e.g., V_{ERASE} - 0 V) will be applied across the hysteretic element and channel. For example, referring to FIG. 2A, a voltage of V_{ERASE} is applied to the conductive material 206 and a voltage of 0 V is applied to the S/D regions 222-1, 222-2, causing a voltage of about V_{ERASE} to be applied across the hysteretic material 208 and the semiconductor material 210 of the channel region 218. In this example, the other memory cells that are not to be erased will have a voltage of about 0 V applied across the hysteretic element and channel of the memory cell, and thus the state of those memory cells should remain unchanged in an ideal case.

Note that although the circuit diagram 900A in FIG. 9A depicts 0 V being applied to the bitlines, source lines, and unselected wordlines, in other implementations, a non-zero voltage may be applied to one or more of the bitlines, source lines, and unselected wordlines, so long as a sufficiently high voltage with the appropriate polarity is applied to the memory cells to be erased without unintentionally changing the values stored in the neighboring memory cells.

FIG. 9B is circuit diagram 900B that depicts an example of voltages applied to control lines in order to program or set a memory cell 902. In one example, the program operation may be considered the opposite of an erase operation for a memory cell that can store one of two states (e.g., an erase operation may cause a memory cell to store a logic '0' and a program operation may cause the memory cell to store a logic '1', or vice versa). However, in other examples, a memory cell may store more than two states (e.g., four states, or a logic '00', logic '01', logic '10' and logic '11'), in which case a program operation may put the memory cell in a particular state associated with the desired logic value. In an example in which the memory cells include FE or AFE storage elements, a program operation may involve applying a sufficiently high voltage with a particular polarity to put the FE/AFE element of the memory cell into a polarization state associated with a program or set state (or other state associated with the logic value to program). In an example in which the memory cells include charge-trapping storage elements, a program operation may involve applying a sufficiently high voltage to cause charge to move into or be added to the charge-trapping element. According to one example, a set state may represent a logic '1'; however, as mentioned above, the states of a memory cell may be assigned to represent a logic '0' and logic '1', and therefore a set state may alternatively represent a logic '0'.

Referring again to FIG. 9B, the source line and bitline coupled with the memory cell 902 to program (e.g., the selected bitline and source line) may be held at 0 V. A voltage V_{PROGRAM} is applied to the wordline coupled with the memory cell that is to be programmed (which may be referred to as the selected wordline), where V_{PROGRAM} has a magnitude that is sufficiently high to put the memory cell in the desired state. If the memory cell 902 was in a state that was different to the desired program state prior to the program operation, application of the voltage V_{PROGRAM} may evoke a change (e.g., a change in polarization state or a change in charge stored in a charge-trapping layer) in the hysteretic element of the memory cell to put the memory cell in the desired program state. Another voltage V_{INHIBIT} may be applied to the unselected wordlines, bitlines, and source lines to prevent unintentional programming of the memory cells coupled with those control lines.

For the memory cell 902 to which V_{PROGRAM} is applied, a voltage of about V_{PROGRAM} (e.g., V_{PROGRAM} - 0 V) will be applied across the hysteretic element and channel. For example, referring to FIG. 2A, a voltage of V_{PROGRAM} is applied to the conductive material 206 and a voltage of 0 V is applied to the S/D regions 222-1, 222-2, causing a voltage of about V_{PROGRAM} to be applied across the hysteretic material 208 and the semiconductor material 210 of the channel region 218. In this example, the other memory cells that are not to be erased will have a voltage that is insufficient to change the state of those memory cells applied across the hysteretic element and channel of the memory cell, and thus the state of those memory cells should remain unchanged in an ideal case. For example, the memory cells coupled with one of the unselected wordlines (e.g., wordlines 820-21, 820-22, 820-23, 820-11, or 820-12) and an unselected source line and bitline (e.g., the bitline 830-2 and the source line 840-2) will see a voltage of about 0 V. The memory cells coupled with one of the unselected wordlines (e.g., wordlines 820-21, 820-22, 820-23, 820-11, or 820-12) and the selected source line and bitline (e.g., the bitline 830-1 and the source line 840-1) will see a voltage of about V_{INHIBIT}(e.g., V_{INHIBIT}- 0 V). The memory cells coupled with the selected wordlines (e.g., wordline 820-13) and an unselected source line and bitline (e.g., the bitline 830-2 and the source line 840-2) will see a voltage of about or V_{PROGRAM} - V_{INHIBIT}.

Note that although the circuit diagram 900B in FIG. 9B depicts 0 V being applied to the selected bitline and source line, in other implementations, a non-zero voltage may be applied so long as a sufficiently high voltage with the appropriate polarity is applied to the memory cell to be programmed. Also, although V_{INHIBIT} is shown as being applied to the unselected wordlines, in other examples, 0 V may be applied to the unselected wordlines. Thus, FIGS. 9A and 9B illustrate example circuit diagrams and voltages to erase and program memory cells in the array 800 of FIG. 8. The magnitude and polarity of V_{PROGRAM}, V_{ERASE}, and V_{INHIBIT} may depend on implementation. In one example, V_{PROGRAM} and V_{ERASE} may have substantially the same magnitude and opposite polarities. In one example, V_{INHIBIT} may have a magnitude that is lower than V_{PROGRAM} to prevent unintentional programming of unselected memory cells.

FIG. 9C is circuit diagram 900C that depicts an example of voltages applied to control lines in order to read a memory cell 902. In order to read the memory cell 902, a voltage having a magnitude sufficient to select but not to program the memory cell 902 is applied to the wordline coupled with the memory cell 902 to read. In the example illustrated in FIG. 9C, a voltage V_{READ} may be applied to the wordline 820-13 coupled with the memory cell 902. The unselected wordlines (e.g., the wordlines 820-21, 820-22, 820-23, 820-11, or 820-12) are held at 0 V. The unselected bitlines and source lines (e.g., the bitline 830-2 and the source line 840-2) are also held at 0 V. A small differential voltage is applied to the selected bitline and wordline coupled with the memory cell 902. In the example illustrated in FIG. 9C, a voltage V₁ is applied to the bitline 830-1 and a voltage V_{1+Δ} is applied to the source line 840-1. In one example, the voltage V₁ - V_{1+Δ} may be around 50 to 250 mV. The application of the voltage across the bitline 830-1 and the source line 840-1 will cause the memory cell 902 to conduct current (e.g., from bitline to source line or vice versa), which may then be detected with a sense amplifier to determine the logic value stored in the memory cell 902. Thus, in some examples, the array 800 may be considered an AND array of AND memory cells, because a memory cell is read only if the wordline and bitline/source line is selected. Accordingly, the memory architecture described herein may be referred to as a 3D AND memory architecture.

Note that although the circuit diagram 900C in FIG. 9C depicts 0 V being applied to the unselected bitlines, source lines, and wordlines, in other implementations, a non-zero voltage may be applied so long as the applied voltages do not cause unintentional programming of the memory cells, and enable an electrical output of the selected memory cell to be sensed in order to determine the logic value stored in that memory cell.

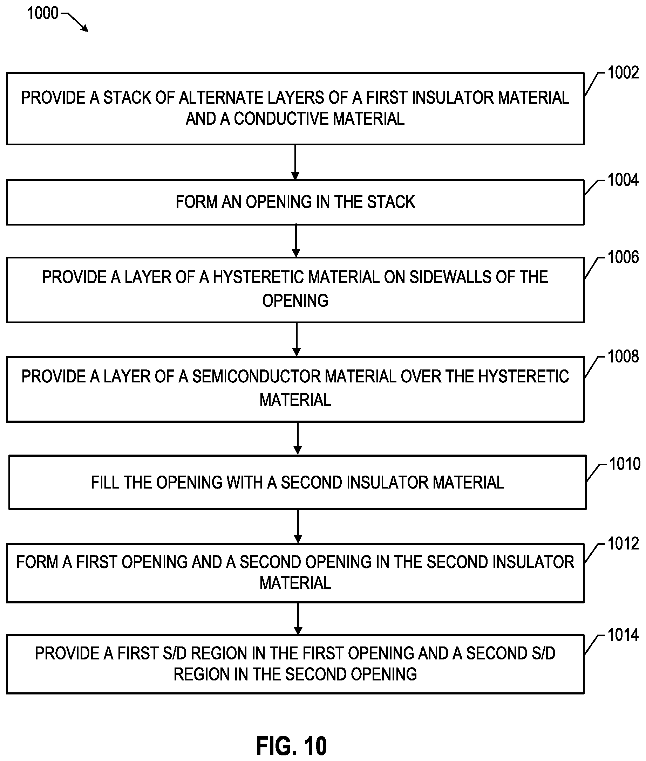

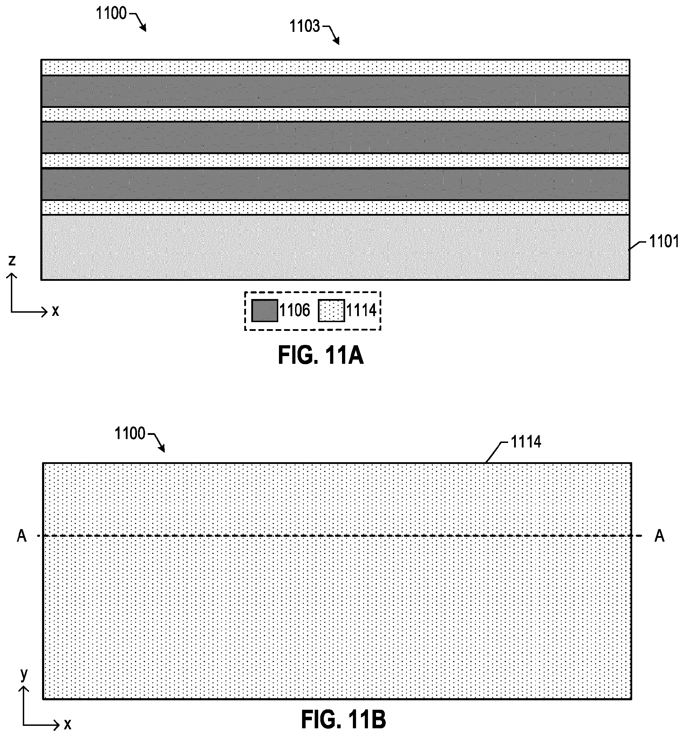

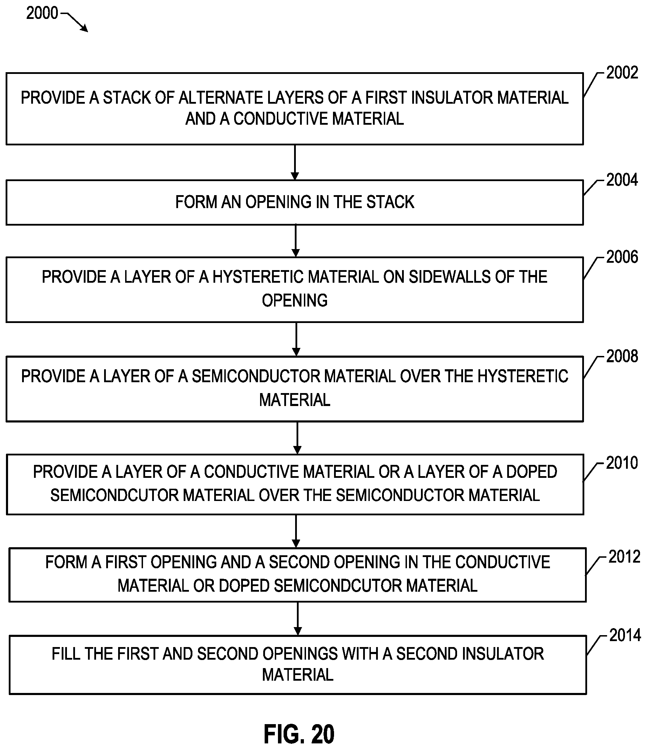

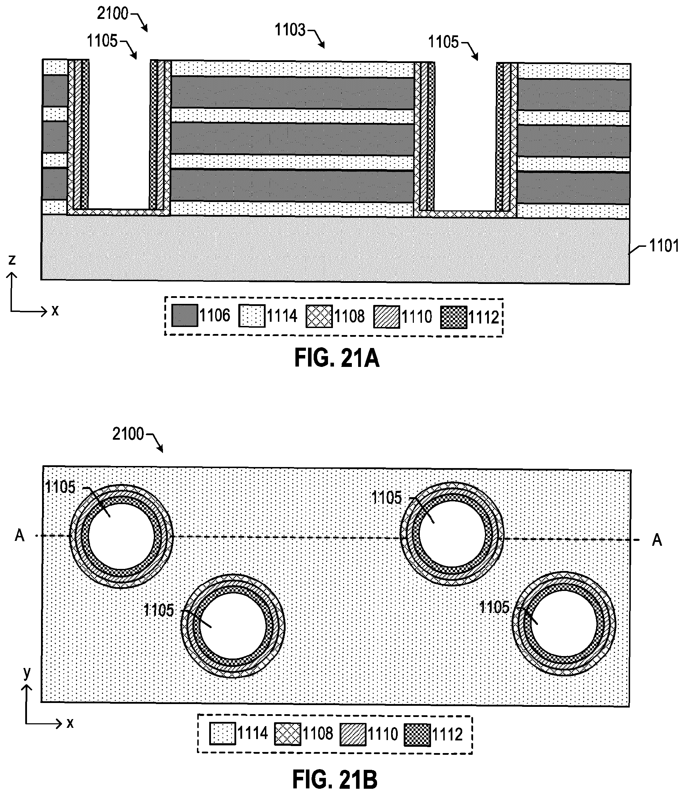

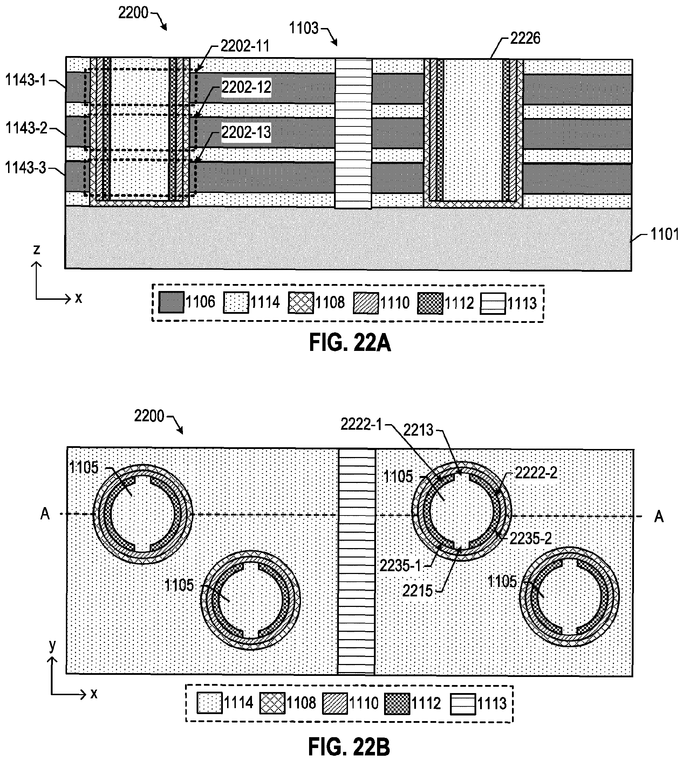

FIGS. 10 and 20 are flow diagrams of example methods for fabricating an IC structure including a one-transistor memory cell with a channel around source and drain regions. 11A-11B, 12A-12B, 13A-13B, 14A-14B, 15A-15B, 16A-16B, 17A-17B, 18A-18B, and 19A-19B21A-21B provide different views at various stages in the fabrication of an example IC structure according to the method of FIG. 10, in accordance with some embodiments. FIGS. 21A-21B and 22A-22B provide different views at various stages in the fabrication of an example IC structure according to the method of FIG. 20, in accordance with some embodiments. FIGS. 11A-11B, 12A-12B, 13A-13B, 14A-14B, 15A-15B, 16A-16B, 17A-17B, 18A-18B, 19A-19B, 21A-21B, and 22A-22B include figures labeled with letters A and B (e.g., FIGS. 11A and 11B), providing different views of a given IC structure. In particular, FIGS. 11A-11B, 12A-12B, 13A-13B, 14A-14B, 15A-15B, 16A-16B, 17A-17B, 18A-18B, 19A-19B, 21A-21B, and 22A-22B that are labeled with a letter A (e.g., FIG. 11A) illustrate cross-sections in the x-z plane of the example coordinate system shown in FIG. 1 along a plane AA shown in a corresponding figure labeled with a letter B (e.g., along a plane AA shown in FIG. 11B). FIGS. 11A-11B, 12A-12B, 13A-13B, 14A-14B, 15A-15B, 16A-16B, 17A-17B, 18A-18B, 19A-19B, 21A-21B, and 22A-22B that are labeled with a letter B (e.g., FIG. 11B) illustrate top-down views in the x-y plane of the example coordinate system shown in FIG. 1. Although the operations of the methods of FIGS. 10 and 20 are illustrated once each and in a particular order, the operations may be performed in any suitable order and repeated as desired. For example, one or more operations may be performed in parallel to fabricate multiple IC structures including a one-transistor memory cell with a channel around source and drain regions substantially simultaneously. In another example, the operations may be performed in a different order to reflect the structure of an IC device in which a one-transistor memory cell with a channel around source and drain regions will be implemented.

In addition, the example fabricating methods of FIGS. 10 and 20 may include other operations not specifically shown in FIGS. 10 and 20, such as various cleaning or planarization operations as known in the art. For example, in some embodiments, a support, as well as layers of various other materials subsequently deposited thereon, may be cleaned prior to, after, or during any of the processes of the methods described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the intermediate IC structures described herein may be planarized prior to, after, or during any of the processes of the methods of FIGS. 10 and 20 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

Turning to FIG. 10, the method 1000 begins with a process 1002 of providing a stack of alternate layers of an insulator material and a conductive material. The IC structure 1100 of FIGS. 11A-11B is an example resulting structure of the process 1002. The IC structure 1100 includes a stack 1103 of alternate layers of an insulator material 1114 and a conductive material 1106 over a substrate 1101. The substrate 1101 may be an example of the support 101 discussed above. The insulator material 1114 may be any suitable insulator material (e.g., any suitable ILD), such as those discussed above. The conductive material may be any suitable wordline material, e.g., a conductive material including a metal, such as those discussed above. As mentioned above, the number of layers of the conductive material 1106 may vary, and although FIG. 11A depicts a stack with three layers of the conductive material 1106, other examples may include a different number of layers of the conductive material 1106.

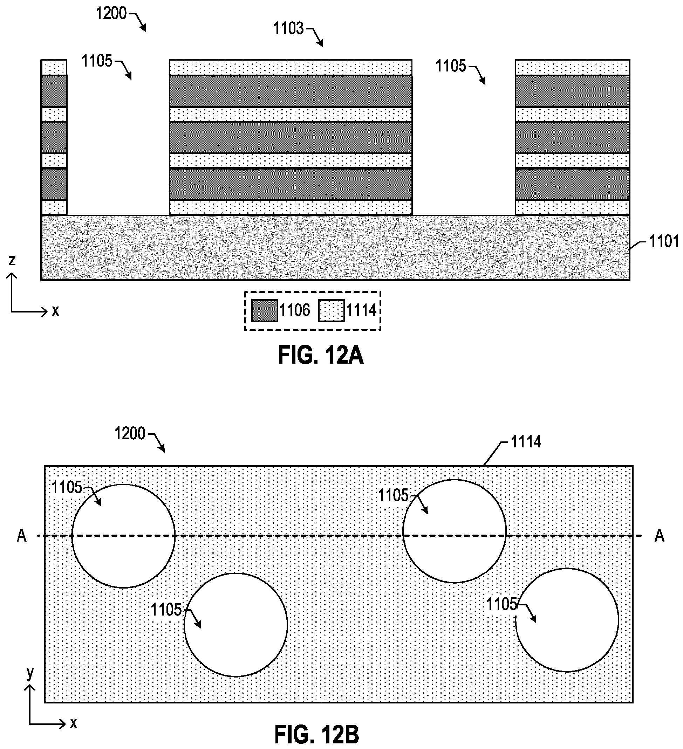

The method 1000 continues with the process 1004 of forming an opening in the stack. The IC structure 1200 of FIGS. 12A-12B is an example resulting structure of the process 1004. The IC structure 1200 includes openings 1105 that extend through the stack 1103 (e.g., at least through the layers of the conductive material 1106). In the examples illustrated in FIG. 12A-12B, the openings 1105 are cylindrical openings. Although FIGS. 12A-12B show the openings 1105 having a same width at both the top and bottom of the openings, the openings in a real fabricated structure may have tapered sidewalls and/or other non-straight features so that the openings are not perfectly cylindrical. In other examples, a cross-section of the openings 1105 along a plane substantially parallel to the substrate 1101 may have a non-circular or non-round shape. For example, a cross-section of the openings 1105 may have corners, and may be, for example, have a shape resembling a hexagon, parallelogram, rectangle, or other shape with four or more corners and sides. In some examples, the openings may have a width in a range of about 30 nanometers to 150 nanometers, where the width is a dimension of an opening in a plane substantially parallel to the substrate 1101 (e.g., in the x-y plane shown in FIG. 12B).

Forming the openings may involve multiple etching processes to remove the various materials in the stack of materials of the preliminary IC structure 1100 (e.g., to remove portions of the conductive material 1106 and the insulator material 1114. Forming the openings may involve any suitable etching technique, e.g., a dry etch, such as e.g., radio frequency (RF) reactive ion etch (RIE) or inductively coupled plasma (ICP) RIE may be used to form the openings 1105. In some embodiments, the etch(es) performed in the process 1004 may include an anisotropic etch, using etchants in a form of e.g., chemically active ionized gas (i.e., plasma). In some embodiments, during the etch of the process 1004, the IC structure may be heated to elevated temperatures, e.g., to temperatures between about room temperature and 200 degrees Celsius, including all values and ranges therein, to promote that byproducts of the etch are made sufficiently volatile to be removed from the surface.

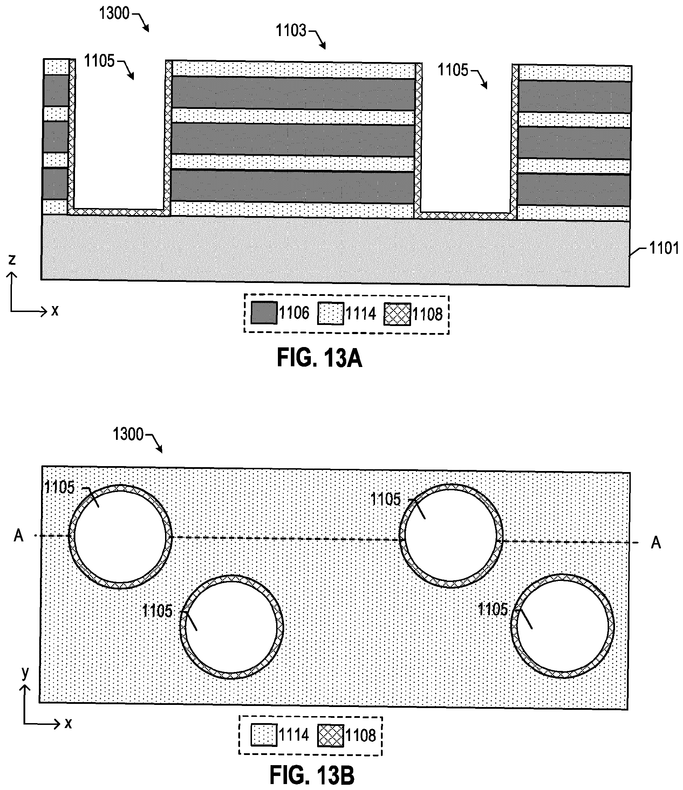

The method 1000 continues with the process 1006 of providing a layer of a hysteretic material on sidewalls of the opening. The IC structure 1300 of FIGS. 13A-13B is an example resulting structure of the process 1006. The IC structure 1300 includes a layer of a hysteretic material 1108 on sidewalls and on bottoms of the openings 1105. In the example illustrated in FIGS. 13A-13B, the layer of the hysteretic material 1108 is a substantially conformal layer on exposed surfaces in the openings 1105. The hysteretic material 1108 may be an example of the hysteretic material 208 discussed above. The layer of hysteretic material 1108 can be deposited in the process 1006 using a technique such as atomic layer deposition (ALD), chemical vapor deposition (CVD), plasma enhanced CVD (PECVD), or/and physical vapor deposition (PVD) processes such as sputter.

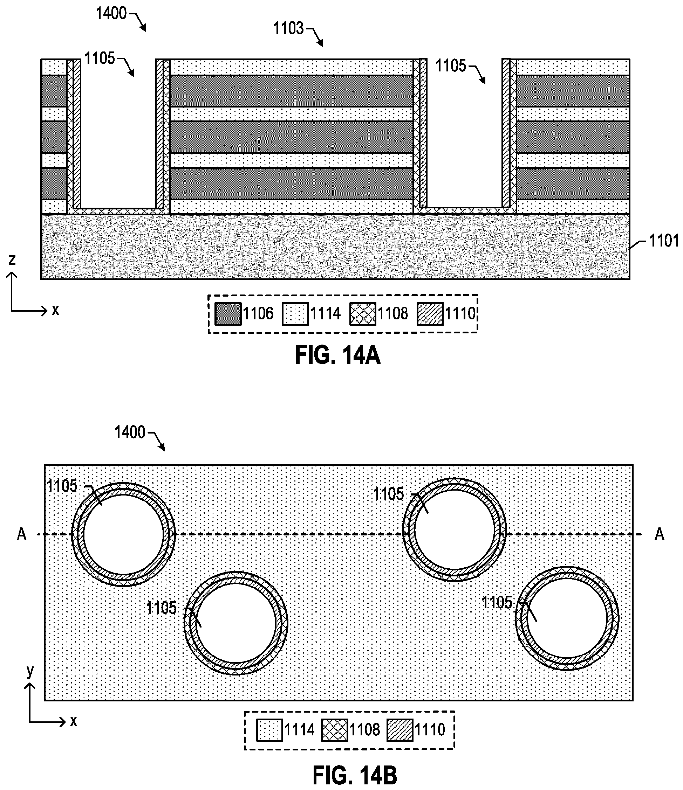

The method 1000 continues with the process 1008 of providing a layer of a semiconductor material over the hysteretic material on sidewalls of the opening. The IC structure 1400 of FIGS. 14A-14B is an example resulting structure of the process 1008. The IC structure 1400 includes a layer of a semiconductor material 1110 over the hysteretic material 1108 on the sidewalls of the openings 1105. In the example illustrated in FIGS. 14A-14B, the layer of the semiconductor material 1110 is a substantially conformal layer. The semiconductor material 1110 may be an example of the semiconductor material 210 discussed above. The layer of semiconductor material 1110 can be deposited in the process 1008 using a suitable deposition technique, such as those discussed above with respect to the process 1006. In one example, the semiconductor material 1110 may be first deposited over both the bottom and on sidewalls of the openings 1105, and then later etched to remove only the portion of the semiconductor material 1110 from the bottom of the openings 1105.

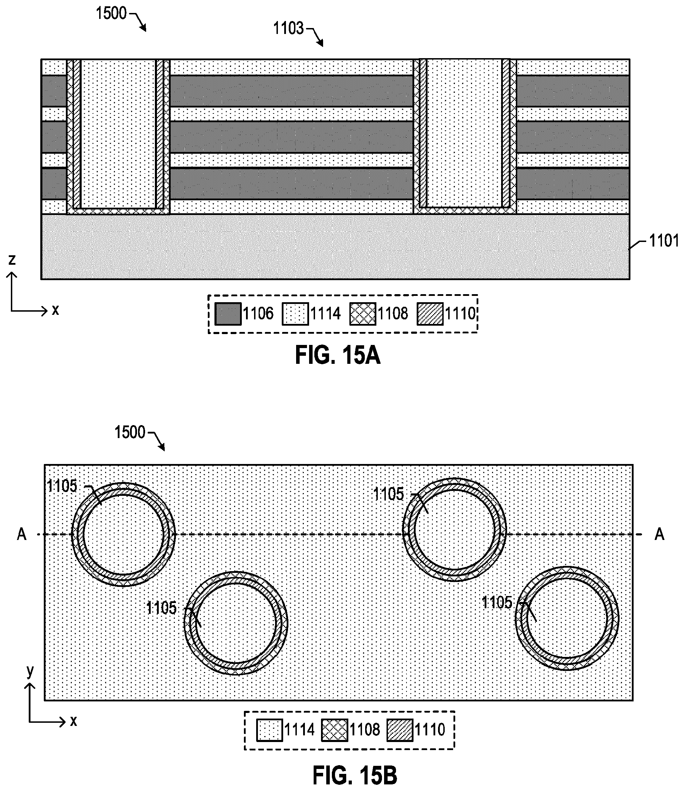

The method 1000 continues with the process 1010 of filling the opening with a second insulator material. The IC structure 1500 of FIGS. 15A-15B is an example resulting structure of the process 1010. As can be seen in FIGS. 15A-15B, the openings 1105 have been filled with an insulator material 1114. The insulator material in the openings 1105 may be an example of the insulator material 224 discussed above. Although FIGS. 15A-15B depict the same insulator material in the stack 1103 and filling the openings 1105, in other examples, the insulator material filling the openings 1105 may be a different insulator material than the insulator material in the stack 1103. The insulator material 1114 may be deposited in the openings 1105 using any suitable deposition technique, such as ALD, CVD, PECVD, or/and PVD processes.

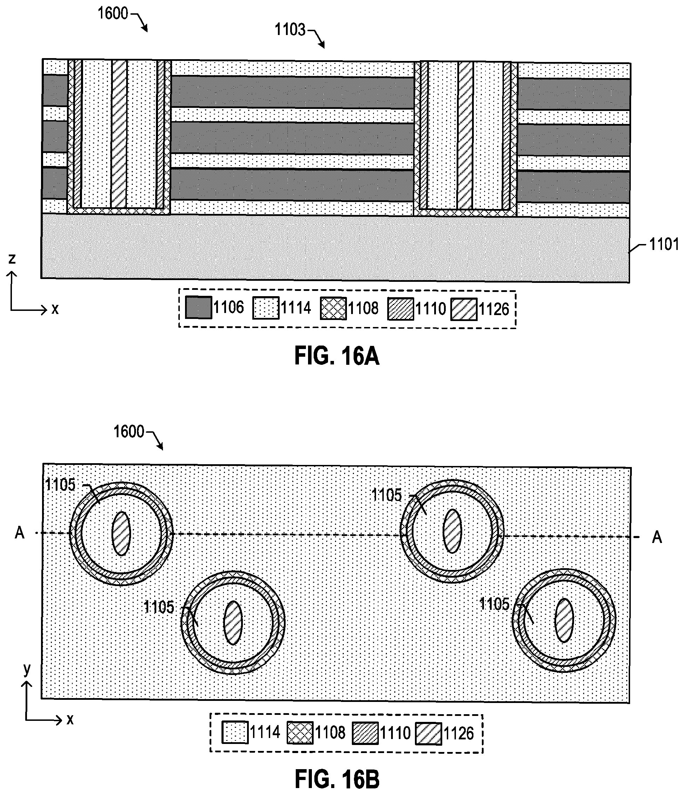

According to some examples, prior to forming the S/D regions in the filled openings, an additional insulator region may be formed in the filled openings. The IC structure 1600 of FIGS. 16A-16B is an example resulting structure of the process of forming an insulator or isolation structure in the filled openings. As can be seen in FIGS. 16A-16B, a second insulator material 1126 may be provided in the filled openings 1105. Providing the second insulator material 1126 may involve first forming a smaller opening in the insulator material 1114 in the opening 1105. In the example illustrated in FIGS. 16A-16B, openings having an oval cross section were formed and filled with the second insulator material 1126 (such as shown in FIGS. 4A-4B); however, in other examples, cylindrical openings or openings having other shapes may be formed and filled with the second insulator material 1126. In one example, a slit (e.g., an opening with a substantially rectangular cross-section) may be formed in the insulator material 1114 in the opening 1105 and filled with the second insulator material 1126 (e.g., such as shown in FIGS. 5A-5B). In other examples, a region of the second insulator material 1126 is not provided in the insulator material 1114 in the opening 1105.

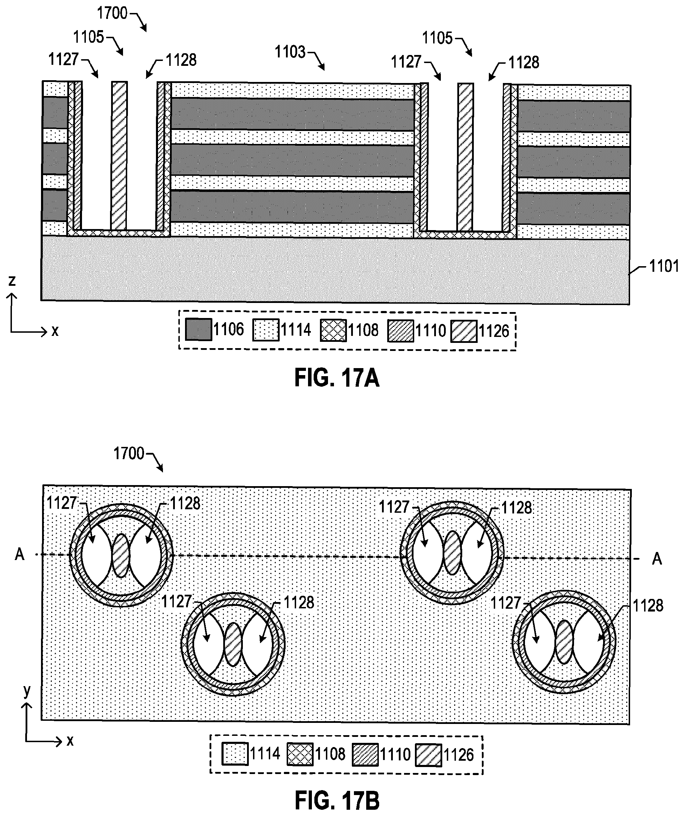

Referring again to FIG. 10, the method 1000 continues with the process 1012 of forming a first opening and a second opening in the second insulator material. The IC structure 1700 of FIGS. 17A-17B is an example resulting structure of the process 1012. As can be seen in FIGS. 17A-17B, a first opening 1127 and a second opening 1128 is formed in the insulator material 1114 in each of the openings 1105. The openings 1127 and 1128 are formed such that a region of the insulator material 1114 and/or a region of the second insulator material 1126 is present between the openings 1127 and 1128. In the example illustrated in FIGS. 17A-17B, the openings 1127, 1128 are formed with a round shape (such as in FIGS. 2A-2B); however, in other examples, the openings 1127, 1128 may be formed with a straight profile (such as in FIGS. 6A-6B). Forming the openings 1127, 1128 may involve any suitable etch technique, such as those discussed above with respect to the process 1004.

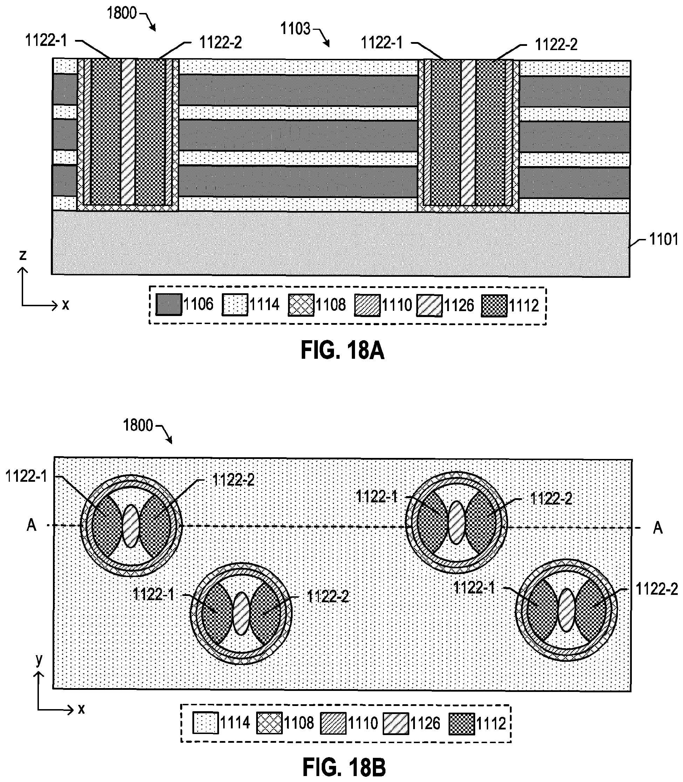

The method 1000 continues with the process 1014 of providing a first S/D region in the first opening and a second S/D region in the second opening. The IC structure 1800 of FIGS. 18A-18B is an example resulting structure of the process 1014. As can be seen in FIGS. 18A-18B, a suitable material 1112 for forming S/D regions 1122-1, 1122-2 has been deposited in the openings 1127, 1128. The material 1112 for the S/D regions may include a conductive material or a doped semiconductor material in accordance with the examples described above. The S/D material 1112 may be deposited in the openings 1127, 1128 using any suitable deposition technique, such as ALD, CVD, PECVD, or/and PVD processes.

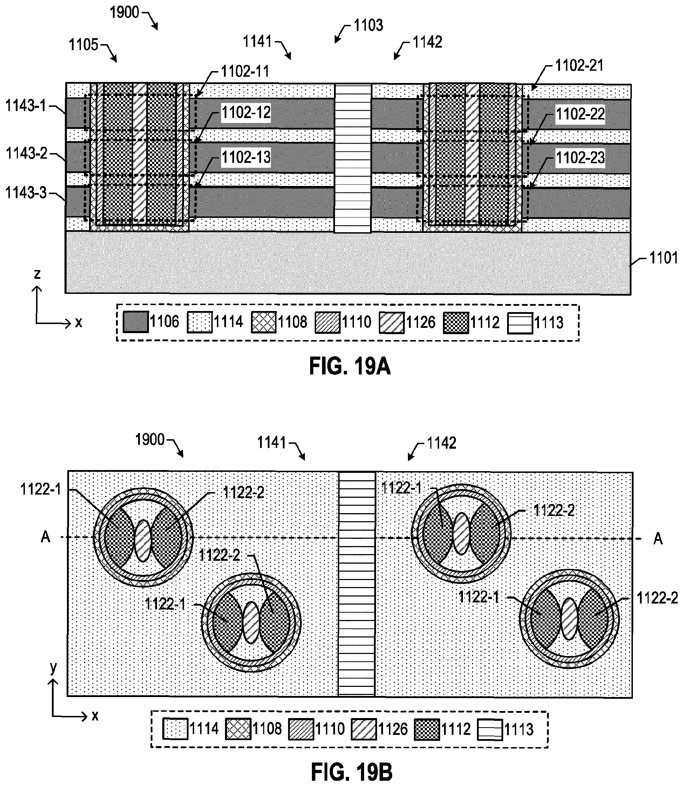

The method 1000 may also involve a process of isolating different portions of the stack 1103 in order to form separate control lines from the layers of conductive material in the stack 1103. The IC structure 1900 of FIGS. 19A-19B is an example resulting structure of the process of forming insulator regions to separate different portions of the stack 1103 from one another. As can be seen in FIGS. 19A-19B, a region of an insulator material 1113 is provided between portions 1141, 1142 of the stack 1103, separating the conductive material 1106 in a given layer into two separate control lines. Although the region of the insulator material 1113 is depicted as being formed after forming the S/D regions 1122-1, 1122-2, in other examples, the region of the insulator material 1113 may be provided in an earlier process (e.g., before forming the openings in the process 1002, or at another point in the method 1000).

Thus, FIG. 10 illustrates a method 1000 for fabricating an IC structure including a one-transistor memory cell with a channel around source and drain regions. Performing the method 1000 may result in several features in the final IC structures that are characteristic of the use of the method 1000. For example, one such feature is illustrated in an IC structure 1900 shown in FIGS. 19A-19B, in which the IC structure includes multiple stacked memory cells in an opening in the stack of alternate layers of an insulator material and a conductive material, where a memory cell has a channel region that wraps around the S/D regions. For example, the stack 1103 includes a first layer 1143-1 of the conductive material 1106, a second layer 1143-2 of the conductive material 1106, and a third layer 1143-3 of the conductive material 1106. A first memory cell 1102-11 including a first transistor is located in the first layer 1143-1 in an opening 1105 (which is now a filled opening) in the stack, a second memory cell 1102-12 including a second transistor is located in the second layer 1143-2 in the opening 1105, and a third memory cell 1102-13 is located in the third layer 1143-3 in the opening 1105. The transistors of the memory cells 1102-11, 1102-12, and 1102-13 include a hysteretic material 1108 on sidewalls of the opening 1105, a first region 1122-1 and a second region 1122-2 in the opening 1105, where one of the first and second regions 1122-1, 1122-2 is a source region of the first, second, and third transistors of the memory cells 1102-11, 1102-12, and 1102-13 and another of the first and second regions 1122-1, 1122-2 is a drain region of the first, second, and third transistors of the memory cells 1102-11, 1102-12, and 1102-13. A semiconductor material 1110 is over the hysteretic material 1108 on the sidewalls of the opening 1105, where a first portion of the semiconductor material 1110 is between the hysteretic material 1108 and the first region 1122-1, and a second portion of the semiconductor material 1110 is between the hysteretic material 1108 and the second region 1122-2. Thus, the S/D regions 1122-1, 1122-2 are shared by the transistors of the memory cells 1102-11, 1102-12, and 1102-13. A second stack of vertically stacked memory cells 1102-21, 1102-22, 1102-23 that is coupled with different wordlines than the memory cells 1102-11, 1102-12, and 1102-13 may be coupled with the same bitlines and source lines as the memory cells 1102-11, 1102-12, and 1102-13.

FIG. 20 is a flow diagram of another example method 2000 for fabricating an IC structure including a one-transistor memory cell with a channel around source and drain regions. The method 2000 differs from the method 1000 in how the S/D regions are formed. As mentioned above, in the method 1000, the S/D regions are formed by filling the openings with an insulator material, forming openings in the insulator material, and then filling those openings with the S/D material. In contrast, in the method 2000, the S/D regions are formed by providing a conformal layer of conductive or semiconductor material over the channel material on the sidewalls of the opening, and etching portions of the layer to form the two S/D regions.

Turning to FIG. 20, the method begins with a process 2002 of providing a stack of alternate layers of an insulator material and a conductive material, a process 2004 of forming an opening in the stack, a process 2006 of providing a hysteretic material on sidewalls of the opening, and a process 2008 of providing a layer of semiconductor material over the hysteretic material. The processes 2002, 2004, 2006, and 2008 may be substantially the same as the processes 1002, 1004, 1006, and 1008 discussed above with respect to FIG. 10. The method continues with a process 2010 of providing a layer of a conductive material or a layer of a doped semiconductor material over the semiconductor material on the sidewalls. The IC structure 2100 of FIGS. 21A-21B is an example resulting structure of the processes 2002, 2004, 2006, 2008, and 2010. The IC structure 2100 includes a layer of the material 1112, which may be a conductive material or a doped semiconductor material. In the example illustrated in FIGS. 21A-21B, the layer of the material 1112 is a substantially conformal layer. According to examples, the thickness of the layer of the material 1112 may be in a range of about 2 to 50 nanometers, where the thickness of the layer of the material 1112 is a dimension of the material in a plane substantially parallel to the substrate (e.g., in the x-y plane as shown in FIG. 21A).

The method may then continue with a process 2012 of forming a first opening and a second opening in the conductive material or doped semiconductor material, and a process 2014 of filling the first and second openings with a second insulator material. The IC structure 2200 of FIGS. 22A-22B is an example resulting structure of the processes 2012 and 2014. Forming the first and second openings may involve etching the material in regions 2215, 2213 (e.g., regions opposite to one another in the opening) to electrically isolate a first portion 2235-1 of the material 1112 from a second portion 2235-2 of the material 1112. Any suitable etch process may be used to remove portions of the material 1112 to form the S/D regions, e.g., any etch process that is selective to the conductive or doped semiconductor material. After etching the material 1112 in the regions 2213, 2215, the layer of the 1112 includes the two portions 2235-1, 2235-2 of the material 1112 to form the S/D regions 2222-1 and 2222-2. The regions 2213, 2215 where the S/D material has been removed may then be filled with an insulator material 2226 (e.g., either the insulator material 1114 as shown, or a different insulator material). The IC structure 2200 also includes a region of an insulator material 1113 to separate portions of the stack 1103, and therefore electrically isolate wordline stacks from one another, as discussed above with respect to FIGS. 19A-19B.

Thus, FIG. 20 illustrates a method 2000 for fabricating an IC structure including a one-transistor memory cell with a channel around source and drain regions. Performing the method 2000 may result in several features in the final IC structures that are characteristic of the use of the method 2000. For example, one such feature is illustrated in an IC structure 2200 shown in FIGS. 22A-22B, in which the IC structure 2200 includes memory cells 2202-11, 2202-12, and 2202-13 stacked over one another, where each of the memory cells 2202-11, 2202-12, and 2202-13 includes a channel region that wraps at least partially around the S/D regions 2222-1, 2222-2. A first S/D region 2222-1 incudes a first portion 2235-1 of a layer of a conductive material or a doped semiconductor material (e.g., the material 1112) over the layer of the semiconductor material on the sidewalls of the opening 1105, and a second S/D region 2222-2 includes a second portion of the layer of the conductive material or doped semiconductor material.

IC devices/structures including a one-transistor memory cell with a channel around source and drain regions as described herein (e.g., as described with reference to FIGS. 1, 2A-2B, 3A-3B, 4A-4B, 5A-5B, 6A-6B, 7A-7B, 8, 9A-9C, 10, 11A-11B, 12A-12B, 13A-13B, 14A-14B, 15A-15B, 16A-16B, 17A-17B, 18A-18B, 19A-19B, 21A-21B, and 22A-22B) may be used to implement any suitable components. For example, in various embodiments, IC devices described herein may be part of one or more of: a central processing unit, a memory device (e.g., a high-bandwidth memory device), a memory cell, a logic circuit, input/output circuitry, a field programmable gate array (FPGA) component such as an FPGA transceiver or an FPGA logic, a power delivery circuitry, an amplifier (e.g., a III-V amplifier), Peripheral Component Interconnect Express (PCIE) circuitry, Double Data Rate (DDR) transfer circuitry, a computing device (e.g., a wearable or a handheld computing device), etc.

The IC devices/structures disclosed herein, e.g., the IC structures 100, 1900, and 2200 and memory cells 202, 302, 402, 502, 602, 702 or any variations thereof, may be included in any suitable electronic component. FIGS. 23-26 illustrate various examples of apparatuses that may include any of the IC devices disclosed herein.

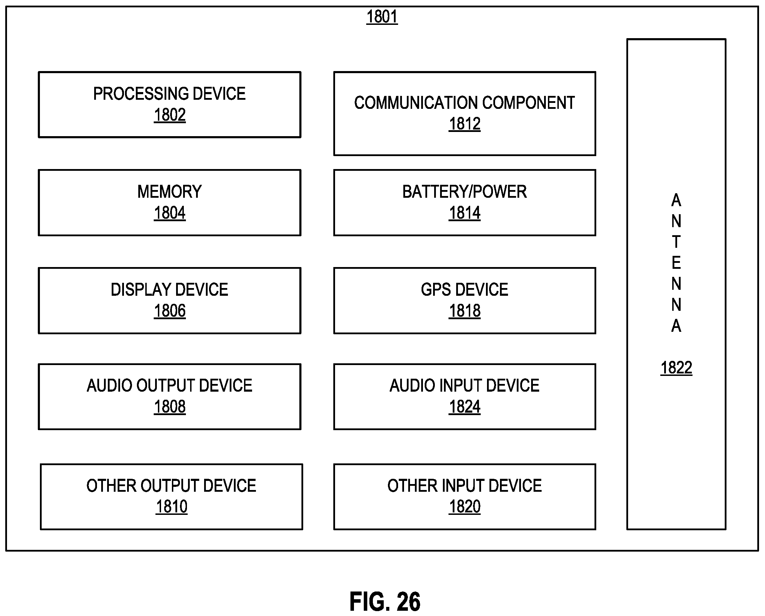

FIG. 23 is a top view of a wafer 1501 and dies 1502 that may include one or more IC structures in accordance with any of the embodiments disclosed herein. The wafer 1501 may be composed of semiconductor material and may include one or more dies 1502 having IC structures formed on a surface of the wafer 1501. Each of the dies 1502 may be a repeating unit of a semiconductor product that includes any suitable IC. After the fabrication of the semiconductor product is complete, the wafer 1501 may undergo a singulation process in which the dies 1502 are separated from one another to provide discrete "chips" of the semiconductor product. The die 1502 may include one or more IC structures as described herein (e.g., any of the IC structures 100, 1900, and 2200 and memory cells 202, 302, 402, 502, 602, 702, or any variations thereof described herein, or any combination of such IC structures), one or more transistors and/or supporting circuitry to route electrical signals to the transistors, as well as any other IC components. In some embodiments, the wafer 1501 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 26) or other logic that is configured to store information in the memory devices or execute instructions stored in the memory array.

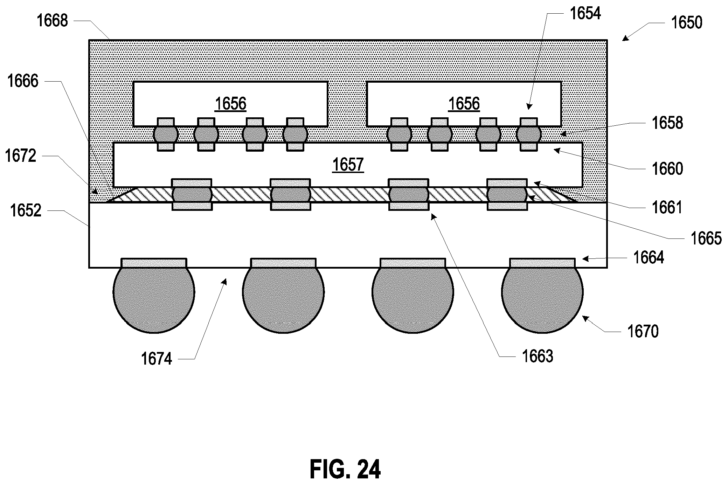

FIG. 24 is a side, cross-sectional view of an example IC package 1650 that may include one or more IC structures in accordance with any of the embodiments disclosed herein (e.g., any of the IC structures 100, 1900, and 2200 and memory cells 202, 302, 402, 502, 602, 702, or any variations thereof described herein, or any combination of such IC structures). In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 24 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 24 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

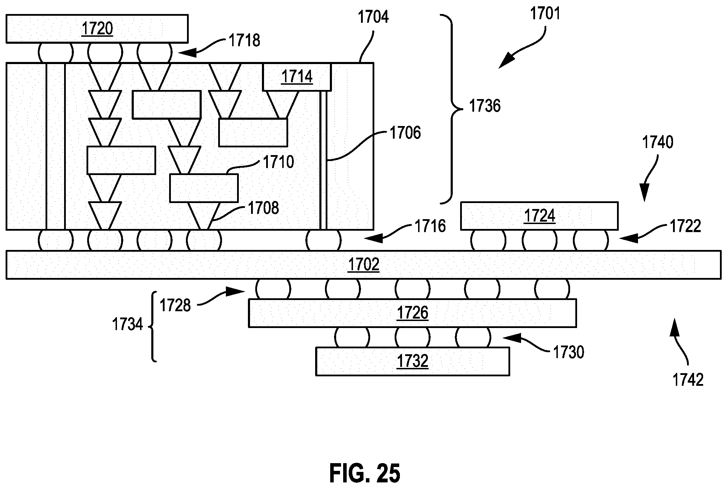

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 24 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 25.

The dies 1656 may take the form of any of the embodiments of the die 1502 discussed herein. In embodiments in which the IC package 1650 includes multiple dies 1656, the IC package 1650 may be referred to as a multi-chip package (MCP). The dies 1656 may include circuitry to perform any desired functionality. For example, or more of the dies 1656 may be logic dies (e.g., silicon-based dies), and one or more of the dies 1656 may be memory dies (e.g., high-bandwidth memory).

Although the IC package 1650 illustrated in FIG. 24 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 24, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 25 is a side, cross-sectional view of an IC device assembly 1701 that may include one or more IC packages or other electronic components (e.g., a die) including one or more IC devices in accordance with any of the embodiments disclosed herein. The IC device assembly 1701 includes a number of components disposed on a circuit board 1702 (which may be, e.g., a motherboard). The IC device assembly 1701 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1701 may take the form of any of the embodiments of the IC package 1650 discussed above with reference to FIG. 24 (e.g., may include one or more of the IC structures 100, 1900, and 2200 and memory cells 202, 302, 402, 502, 602, 702, or any variations thereof described herein, or any combination of such IC structures).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1701 illustrated in FIG. 25 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 25), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 25, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 23), an IC device (e.g., any of the IC structures 100, 1900, and 2200 and memory cells 202, 302, 402, 502, 602, 702, or any variations thereof described herein, or any combination of such IC structures), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 25, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1701 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1701 illustrated in FIG. 25 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 26 is a block diagram of an example electrical device 1801 that may include one or more IC structures 100 in accordance with any of the embodiments disclosed herein. For example, any suitable ones of the components of the electrical device 1801 may include one or more of the IC device assemblies 1701, IC packages 1650, or dies 1502 disclosed herein. A number of components are illustrated in FIG. 26 as included in the electrical device 1801, but any one or more of these components may be omitted or duplicated, as suitable for the application. In some embodiments, some or all of the components included in the electrical device 1801 may be attached to one or more motherboards. In some embodiments, some or all of these components are fabricated onto a single system-on-a-chip (SoC) die.

Additionally, in various embodiments, the electrical device 1801 may not include one or more of the components illustrated in FIG. 26, but the electrical device 1801 may include interface circuitry for coupling to the one or more components. For example, the electrical device 1801 may not include a display device 1806, but may include display device interface circuitry (e.g., a connector and driver circuitry) to which a display device 1806 may be coupled. In another set of examples, the electrical device 1801 may not include an audio input device 1824 or an audio output device 1808, but may include audio input or output device interface circuitry (e.g., connectors and supporting circuitry) to which an audio input device 1824 or audio output device 1808 may be coupled.

The electrical device 1801 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1801 may include a memory 1804, which may itself include one or more memory devices such as volatile memory (e.g., dynamic random-access memory (DRAM)), non-volatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random-access memory (eDRAM) or spin transfer torque magnetic random-access memory (STT-MRAM).

In some embodiments, the electrical device 1801 may include a communication chip 1812 (e.g., one or more communication chips). For example, the communication chip 1812 may be configured for managing wireless communications for the transfer of data to and from the electrical device 1801. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1801 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1801 may include battery/power circuitry 1814. The battery/power circuitry 1814 may include one or more energy storage devices (e.g., batteries or capacitors) and/or circuitry for coupling components of the electrical device 1801 to an energy source separate from the electrical device 1801 (e.g., AC line power).

The electrical device 1801 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1801 may include an audio output device 1808 (or corresponding interface circuitry, as discussed above). The audio output device 1808 may include any device that generates an audible indicator, such as speakers, headsets, or earbuds.

The electrical device 1801 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1801 may include a GPS device 1818 (or corresponding interface circuitry, as discussed above). The GPS device 1818 may be in communication with a satellite-based system and may receive a location of the electrical device 1801, as known in the art.

The electrical device 1801 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1801 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1801 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1801 may be any other electronic device that processes data.

The following paragraphs provide various examples of the embodiments disclosed herein.

Example 1 provides an IC structure, including a memory cell including a transistor over a substrate, where the transistor includes a source region, a drain region, an insulator material between the source region and the drain region in a plane substantially parallel to the substrate, a semiconductor material (e.g., a channel region) surrounding the source region and the drain region in the plane, and a hysteretic material surrounding the semiconductor material in the plane; a first conductive line coupled with the source region; a second conductive line coupled with the drain region; and a third conductive line including a portion of conductive material surrounding the hysteretic material in the plane.

Example 2 provides the IC structure of example 1, where: the source region includes a first continuous portion of a conductive material or a doped semiconductor material in contact with and between a first portion of the semiconductor material and the insulator material, and the drain region includes a second continuous portion of the conductive material or the doped semiconductor material in contact with and between a second portion of the semiconductor material and the insulator material (e.g., opposite the first portion in the plane).

Example 3 provides the IC structure of examples 1 or 2, where: the source region has a first curved convex portion in contact with the insulator material in a cross-section of the memory cell in the plane, and the drain region has a second curved convex portion in contact with the insulator material in a cross-section of the memory cell in the plane.

Example 4 provides the IC structure of examples 1 or 2, where: the source region has a substantially straight portion in contact with the insulator material in a cross-section of the memory cell in the plane, and the drain region has a second curved convex portion in contact with the insulator material in a cross-section of the memory cell in the plane.

Example 5 provides the IC structure of any one of examples 1-4, where: the conductive material is in contact with the hysteretic material.

Example 6 provides the IC structure of any one of examples 1-5, where: the hysteretic material includes a ferroelectric material or an antiferroelectric material.

Example 7 provides the IC structure of any one of examples 1-5, where: the hysteretic material includes a charge-trapping material.

Example 8 provides the IC structure of any one of examples 1-7, where: the memory cell is in an opening in the conductive material, the hysteretic material includes a first layer of the hysteretic material on sidewalls of the opening, and the semiconductor material includes a second layer of the semiconductor material over the first layer on the sidewalls.

Example 9 provides the IC structure of example 8, where: the first layer and the second layer have substantially circular cross-sectional shapes in the plane.

Example 10 provides the IC structure of examples 8 or 9, where: a thickness of the second layer of the semiconductor material is in a range of about 3-20 nanometers, where the thickness is a dimension of the second layer in the plane and/or a thickness of the first layer of the hysteretic material is in a range of about 3-20 nanometers, where the thickness is a dimension of the first layer in the plane.

Example 11 provides the IC structure of any one of examples 8-10, wherein the source region includes a first portion of a third layer of a conductive material or a doped semiconductor material over the second layer on the sidewalls, and the drain region includes a second portion of the third layer (e.g., opposite the first portion and separated by portions of an insulator material)

Example 12 provides the IC structure of any one of examples 1-11, where the insulator material is a first insulator material, and where the IC structure further includes a second insulator material (e.g., SiN) between the source region and the drain region along a first axis in the plane, where: the second insulator material is between portions of the first insulator material along a second axis in the plane, and the second axis is orthogonal to the first axis.

Example 13 provides the IC structure of any one of examples 1-12, further including a gate insulator material between the hysteretic material and the semiconductor material.

Example 14 provides an IC structure, including a stack of alternate layers of an insulator material and a conductive material, where the stack includes a first layer of the conductive material and a second layer of the conductive material; a first memory cell including a first transistor in the first layer in an opening in the stack; and a second memory cell including a second transistor in the second layer in the opening, where the first transistor and the second transistor include a hysteretic material on sidewalls of the opening, a first region and a second region in the opening, where one of the first region and the second region is a source region of the first and second transistors and another of the first region and the second region is a drain region of the first and second transistors, and a semiconductor material over the hysteretic material on the sidewalls, where a first portion of the semiconductor material is between the hysteretic material and the first region, and a second portion of the semiconductor material is between the hysteretic material and the second region.

Example 15 provides the IC structure of example 14, further including a second insulator material between the first region and the second region.

Example 16 provides the IC structure of example 15, where: the second insulator material is between the first region and the second region in a first plane orthogonal to the first layer, and a third insulator material is between the first region and the second region in a second plane that is parallel to the first plane.

Example 17 provides the IC structure of any one of examples 15-16, where: the first region includes a first continuous portion of a conductive material or a doped semiconductor material in contact with and between a first portion of the semiconductor material and the second insulator material, and the second region includes a second continuous portion of the conductive material or the doped semiconductor material in contact with and between a second portion of the semiconductor material and the second insulator material.

Example 18 provides the IC structure of any one of examples 15-17, where: the second insulator material includes a first portion proximate to a first sidewall portion of the opening, a second portion proximate to a second sidewall portion of the opening opposite the first sidewall portion, and a third portion between the first portion and the second portion, where the third portion has a narrower width than the first and second portions, where the width is a dimension of the second insulator material between the first region and the second region in a plane substantially parallel with the first layer.

Example 19 provides the IC structure of any one of examples 15-17, where: the second insulator material includes a first portion proximate to a first sidewall portion of the opening, a second portion proximate to a second sidewall portion of the opening opposite the first sidewall portion, and a third portion between the first portion and the second portion, where the first portion, second portion, and third portion have a substantially same width, where the width is a dimension of the second insulator material between the first region and the second region in a plane substantially parallel with the first layer.

Example 20 provides the IC structure of any one of examples 14-17, further including a first conductive line coupled with the first region; and a second conductive line coupled with the second region, where: the first layer is a third conductive line including a first portion of the conductive material surrounding the hysteretic material, and the second layer is another third conductive line including a second portion of the conductive material surrounding the hysteretic material.

Example 21 provides the IC structure of any one of examples 14-20, where: the hysteretic material includes a ferroelectric material or an antiferroelectric material.

Example 22 provides the IC structure of any one of examples 14-20, where: the hysteretic material includes a charge-trapping material.

Example 23 provides the IC structure of any one of examples 14-22, further including a gate insulator material between the hysteretic material and the semiconductor material.

Example 24 provides an IC structure according to any one of examples 1-23, where the IC structure includes or is a part of a central processing unit.

Example 25 provides an IC structure according to any one of examples 1-24, where the IC structure includes or is a part of a memory device.

Example 26 provides an IC structure according to any one of examples 1-25, where the IC structure includes or is a part of a logic circuit.

Example 27 provides an IC structure according to any one of examples 1-26, where the IC structure includes or is a part of input/output circuitry.

Example 28 provides an IC structure according to any one of examples 1-27, where the IC structure includes or is a part of a field programmable gate array transceiver.

Example 29 provides an IC structure according to any one of examples 1-28, where the IC structure includes or is a part of a field programmable gate array logic.

Example 30 provides an IC structure according to any one of examples 1-29, where the IC structure includes or is a part of a power delivery circuitry.

Example 31 provides an IC package that includes an IC die including an IC structure according to any one of examples 1-30; and a further IC component, coupled to the IC die.

Example 32 provides an IC package according to example 31 where the further IC component includes a package substrate.

Example 33 provides an IC package according to example 31, where the further IC component includes an interposer.

Example 34 provides an IC package according to example 31, where the further IC component includes a further IC die.

Example 35 provides a computing device that includes a carrier substrate and an IC structure coupled to the carrier substrate, where the IC structure is an IC structure according to any one of examples 1-30, or the IC structure is included in the IC package according to any one of examples 31-34.

Example 36 provides a computing device according to example 35, where the computing device is a wearable or handheld computing device.

Example 37 provides a computing device according to examples 35 or 36, where the computing device further includes one or more communication chips.

Example 38 provides a computing device according to any one of examples 35-37, where the computing device further includes an antenna.

Example 39 provides a computing device according to any one of examples 35-37, where the carrier substrate is a motherboard.

Example 40 provides a method of fabricating an IC structure, the method including providing a stack of alternate layers of a first insulator material and a conductive material; forming a first opening in the stack through the alternate layers; providing a layer of a hysteretic material on sidewalls of the opening; providing a layer of a semiconductor material over the hysteretic material on the sidewalls; filling the first opening with a second insulator material over the layer of the semiconductor material; forming a second opening and a third opening in the second insulator material, where the second opening and the third opening are opposite one another and separated by a portion of the second insulator material; providing a doped semiconductor material or a conductive material in the second opening and the third opening; and providing a first control line coupled with the doped semiconductor material or the conductive material in the second opening and a second control line coupled with the doped semiconductor material or the conductive material in the third opening.

Example 41 provides the method of example 40, further including forming a fourth opening (e.g., a slit) through the layers of conductive material in the stack, where the fourth opening separates a first portion of the layers from a second portion of the layers; and filling the opening with a third insulator material.

Example 42 provides the method of examples 40 or 41, where: forming the first opening includes forming the first opening having a substantially circular cross-section in a plane that is substantially parallel with a substrate over which the stack is disposed.

Example 43 provides the method of any one of examples 40-42, further including after filling the first opening, forming a fifth opening in a middle of the second insulator material; and filling the fifth opening with a third insulator material.

Example 44 provides a method according to any one of examples 40-43, where the IC structure is an IC structure according to any one of the preceding examples.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a memory cell comprising a transistor over a substrate, wherein the transistor comprises:
a source region,
a drain region,
an insulator material between the source region and the drain region in a plane substantially parallel to the substrate,
a semiconductor material surrounding the source region and the drain region in the plane, and
a hysteretic material surrounding the semiconductor material in the plane;
a first conductive line coupled with the source region;
a second conductive line coupled with the drain region; and
a third conductive line including a portion of conductive material surrounding the hysteretic material in the plane.

2. The IC structure of claim 1, wherein the conductive material is a first conductive material, and wherein:
the source region includes a first continuous portion of a second conductive material or a doped semiconductor material in contact with and between a first portion of the semiconductor material and the insulator material, and
the drain region includes a second continuous portion of the second conductive material or the doped semiconductor material in contact with and between a second portion of the semiconductor material and the insulator material.

3. The IC structure of claims 1 or 2, wherein:
the source region has a first curved convex portion in contact with the insulator material in a cross-section of the memory cell in the plane, and
the drain region has a second curved convex portion in contact with the insulator material in the cross-section of the memory cell in the plane.

4. The IC structure of claims 1 or 2, wherein:
the source region has a substantially straight portion in contact with the insulator material in a cross-section of the memory cell in the plane, and
the drain region has a second curved convex portion in contact with the insulator material in the cross-section of the memory cell in the plane.

5. The IC structure of any one of claims 1-4, wherein:
the conductive material is in contact with the hysteretic material.

6. The IC structure of any one of claims 1-5, wherein:
the hysteretic material comprises a ferroelectric material or an antiferroelectric material.

7. The IC structure of any one of claims 1-5, wherein:
the hysteretic material comprises a charge-trapping material.

8. The IC structure of any one of claims 1-7, wherein:
the memory cell is in an opening in the conductive material,
the hysteretic material comprises a first layer of the hysteretic material on sidewalls of the opening, and
the semiconductor material comprises a second layer of the semiconductor material over the first layer on the sidewalls.

9. The IC structure of claim 8, wherein:
the first layer and the second layer have substantially circular cross-sectional shapes in the plane.

10. The IC structure of claims 8 or 9, wherein:
a thickness of the second layer of the semiconductor material is in a range of about 3-20 nanometers, wherein the thickness is a dimension of the second layer in the plane.

11. The IC structure of any one of claims 8-10, wherein:
a thickness of the first layer of the hysteretic material is in a range of about 3-20 nanometers, wherein the thickness is a dimension of the first layer in the plane.

12. The IC structure of any one of claims 8-11, wherein the conductive material is a first conductive material, and wherein:
the source region comprises a first portion of a third layer of a second conductive material or a doped semiconductor material over the second layer on the sidewalls, and the drain region comprises a second portion of the third layer.

13. The IC structure of any one of claims 1-12, wherein the insulator material is a first insulator material, and wherein the IC structure further comprises:
a second insulator material between the source region and the drain region along a first axis in the plane, wherein:
the second insulator material is between portions of the first insulator material along a second axis in the plane, and
the second axis is orthogonal to the first axis.

14. A method of fabricating an integrated circuit (IC) structure, the method comprising:
providing a stack of alternate layers of a first insulator material and a first conductive material;
forming a first opening in the stack through the alternate layers;
providing a first layer of a hysteretic material on sidewalls of the first opening;
providing a second layer of a semiconductor material over the hysteretic material on the sidewalls;
filling the first opening with a second insulator material over the second layer of the semiconductor material;
forming a second opening and a third opening in the second insulator material, wherein the second opening and the third opening are opposite one another and separated by a portion of the second insulator material;
providing a doped semiconductor material or a second conductive material in the second opening and the third opening; and
providing a first control line coupled with the doped semiconductor material or the second conductive material in the second opening and a second control line coupled with the doped semiconductor material or the second conductive material in the third opening.

15. The method of claim 14, further comprising:
after filling the first opening, forming a fourth opening in a middle of the second insulator material; and
filling the fourth opening with a third insulator material.
